# EUROPÄISCHE PATENTSCHRIFT

(11) **EP 1 506 054 B1**
(45) Veröffentlichungstag und Bekanntmachung des Hinweises auf die Patenterteilung: **25.07.2012**
(21) Anmeldenummer: 03718709.3
(22) Anmeldetag: 26.03.2003
(51) Int. Cl.: B01J 19/00, H01L 23/473, F28D 9/00

(54) **MIKROREAKTOR UND MIKROWÄRMEÜBERTRAGER**
MICRO-REACTOR AND MICRO-CHANNEL HEAT EXCHANGER
MICROREACTEUR ET MICRO-ECHANGEUR THERMIQUE

(30) Priorität: 26.03.2002 DE 10213500
(43) Veröffentlichungstag der Anmeldung: 16.02.2005
(73) Patentinhaber: Prechtl, Peter, 81241 Munchen (DE)
(72) Erfinder: Prechtl, Peter, 81241 Munchen (DE)
(74) Vertreter: Lindner, Michael
(86) Internationale Anmeldenummer: PCT/EP2003/003137
(87) Internationale Veröffentlichungsnummer: WO 2003/080233

(56) Entgegenhaltungen:
- EP-A- 0 903 174
- EP-A- 0 930 123
- WO-A-01/41916
- WO-A-97/32687
- WO-A-98/37457
- US-A- 4 516 632
- US-A- 5 727 618

## Beschreibung

Die vorliegende Erfindung betrifft einen Mikroreaktor mit mehreren, zu einem schichtenstapel zusammengefassten einzelnen Schichten, welcher Schichtenstapel eine Deckschicht und eine Kanalschicht aufweist, wobei die Ranalschichtrauf Zumindest zwei einzelne Schichten umfasst, die jeweils auf Zumindest einer Seite Mikrostrukturen aufweist, die zusammen mit der zugewandten Seite der benachbarten Deckschicht bzw. der einzelnen Schicht Mikrokanäle bilden, und zumindest einem Einlaufkanal und zumindest einem Auslaufkanal, die mit den Mikrokanälen in Verbindung stehen, so dass ein über dem Einlaufkanal eingeleitetes Medium die Mikrokanäle durchströmen und über den Auslaufkanal ausströmen kann, und einen Mikroreaktorbereich bilden.

Mikroreaktoren der vorgenannten Art sind allgemein bekannt bspw. aus EP 0 903 174 A1, wobei im Zusammenhang mit der vorliegenden Erfindung unter Mikroreaktor allgemein ein System bezeichnet wird, dass zur Übertragung bzw. zum Austausch von Energie, insbesondere Wärmeenergie, in der Lage ist, wobei hierfür mindestens ein Medium den Mikroreaktor durchströmt. Zu diesen Mikroreaktoren zählen beispielsweise chemische Reaktoren sowie Wärmeübertrager bzw. Wärmetauscher, die entweder Wärme zwischen zwei Fluiden oder zwischen einem Fluid und einem festen Material austauschen, wobei die vorgenannten Reaktoren unter Verwendung der Mikrostrukturtechnologie hergestellt sind. Mithilfe dieser Technologie lassen sich kleinste Kanäle mit Dimensionen unter einem Millimeter herstellen. So konnten damit die klassischen Wärmeübertrager bzw. chemischen Reaktoren weiter miniaturisiert werden, indem die mit dem Fluid durchströmen Kanäle als Mikrokanäle ausgebildet wurden.

Die Mikrostrukturtechnologie selbst ist seit den 80-Jahren in den verschiedensten technischen Bereichen mehr oder weniger stark verbreitet. Als Beispiele sind hier die bereits zitierten Bereiche der Wärmetauscher und der chemischen Reaktoren für Sonderprozesse im kleinen Maßstab zu nennen. Zwei Gründe die eine wesentlich stärkere Nutzung der Mikrostrukturtechnologie bis jetzt verhindert haben, sind die fehlende Option einer effizienten Hochskalierung der Bauteile für größere Massenströme und Leistungen ohne die Erzeugung von inakzeptablen Druckverlusten und die Möglichkeit, diese durch intelligentes Design für geeignete Fertigungsverfahren kosteneffizient in großen Stückzahlen herstellen zu können.

Die Mikrostrukturtechnologie, hat ihren Hauptvorteil in der Verwendung laminarer Strömungen in kleinen Kanälen. Bei konventionellen Reaktoren und Wärmetauschern übertragen turbulente Strömungen die Wärme durch Konvektion in Rohren oder Platten. So wie turbulente Ströme durch ein Rohr oder zwischen Platten fließen, bildet sich eine laminare Grenzschicht am Übergang zum festen Medium(Wand). Diese flüssige Grenzschicht behindert maßgeblich den Wärmeübergang ins feste Medium. Wird nun in konventionellen Reaktoren oder Wärmetauschern die Fließgeschwindigkeit reduziert, vergrößert sich die laminare Grenzschicht und verschlechtert den Wärmeübergang. Dadurch, dass in mikrostrukturierten Reaktoren idealer weise die komplette ausgebildete Strömung laminar verläuft, kann eine Reduzierung der Fließgeschwindigkeit die laminare Grenzschicht nicht mehr anwachsen lassen. Folglich hat die Verringerung der Fluidgeschwindigkeit in einem mikrostrukturierten Reaktor im Vergleich zu einem konventionellen Reaktor mit großen Kanälen nur einen sehr geringen Einfluss auf die Wärmeübertagungsleistung. Das bedeutet, dass ein Mikroreaktor einen wesentlich erweiterten Dynamikbereich besitzt, wo ein hoher Wirkungsgrad erzielt werden kann. Damit ist der Mikroreaktor auch in dynamischen Systemen bzw. in Anwendungen mit unterschiedlichen Lastbereichen im Gegensatz zum konventionellen Reaktor sehr effizient.

Einer der größten Nachteile von mikrostrukturierten Reaktoren, wie sie bisher bekannt sind, ist der infolge von Reibungsverlusten mögliche hohe Druckverlust. Dieser Effekt zwingt dazu, die Mikrokanäle möglichst kurz zu gestalten. Dies ist für kleine Anwendungen durchaus machbar. Um aber die überragenden Wärmeübertragungseigenschaften der Mikrostrukturtechnologie im großen Maßstab einsetzen zu können und dabei nicht durch das Problem der steigenden Druckverluste zu laufen, sind die bisherigen Konzepte nicht nutzbar.

Obgleich sich also mithilfe der Mikrostrukturtechnologie sehr leistungsfähige Mikroreaktoren bzw. Mikrowärmeübertrager herstellen lassen, tauchen insbesondere bei der Skalierung der mit Mikrostrukturen versehenen Elemente Probleme auf, die zu einer Leistungsverminderung führen. Diese Probleme ergeben sich -wie erwähnt- insbesondere durch den stark ansteigenden Strömungswiderstand in den Mikrokanälen, der mit der Verlängerung von Mikrokanälen einhergeht. Dieser zunehmende Strömungswiderstand führt zu einem Druckverlust in den Mikrokanälen, was in der Regel nur durch eine überproportionale Erhöhung der Anzahl der Mikrokanäle kompensiert werden kann. Dies hat jedoch wiederum den Nachteil, dass nicht nur die Abmessungen des gesamten Mikroreaktors, sondern auch dessen Gewicht zunimmt. Zudem wird der Mikroreaktor deutlich teurer, womit er, gerade in sehr preisumkämpften Bereichen wie dem Automobilbereich oder dem Computerbereich, als Mikrowärmeübertrager zur Kühlung von elektronischen Bauteilen, wie CPU, etc. uninteressant wird.

Ein.weiteres Problem, dass sich beim Skalieren bisheriger Mikroreaktoren zu höheren Leistungen ergibt, ist in einem sehr hohen Druckverlust in den Einlauf- und Auslaufbereichen vor und nach den Mikrokanälen zu sehen. Dies liegt insbesondere daran, dass sich beim Skalieren die Länge der Kanäle in den Einlauf- und Auslaufbereichen deutlich vergrößert, was folglich den Strömungswiderstand und damit auch den Druckverlust in diesen Bereichen erhöht.

Ein Wärmetauscher mit Mikrokanälen ist beispielsweise in US 4,516,632 offenbart. Dieser Wärmetauscher besteht aus einer Vielzahl von aufeinander gestapelten Schichten, wobei sich geschlitzte mit ungeschlitzten Schichten abwechseln. Die geschlitzten Schichten weisen gerade und parallel zueinander angeordnete Schlitze auf, die zusammen mit den benachbarten ungeschlitzten Schichten Mikrokanäle bilden. Zum Aufbau eines Kreuzstrom-Flüssigkeitswärmetauschers sind die Schlitze aufeinanderfolgender geschlitzter Schichten um 90° verdreht. Die Zuführung der zum Wärmetausch benötigten Flüssigkeiten erfolgt zu den einzelnen Schichten über Einlaufbereiche bzw. Auslaufbereiche, die in den benachbarten ungeschlitzten Schichten als Öffnungen vorgesehen sind.

Ein wesentlicher Nachteil dieses Kreuzstrom-Flüssigkeitswärmetauschers ist darin zu sehen, dass ungeschlitzte Schichten eingesetzt werden müssen, die einerseits die Kosten und andererseits die Abmessungen und das Gewicht des Bauteils erhöhen. Darüber hinaus ergeben sich auch hier Druckverluste in den Einlauf- bzw. Auslaufbereichen zu den einzelnen geschlitzten Schichten.

Ein weiterer Wärmetauscher mit Mikrokanälen ist aus WO 99/66279 bekannt. Auch hier ist ein Wärmetauscher in Kreuzstrom-Anordnung gezeigt und sind eine Vielzahl von Schichten aufeinander gestapelt, wobei jede Schicht über Mikrokanäle verfügt, die eine Fluidverbindung zwischen einem Einlaufbereich und einem Auslaufbereich herstellen. Aufeinanderfolgende Schichten in dieser Anordnung haben um 90° zueinander versetzte Mikrokanäle, so dass sich ebenfalls eine Kreuzstrom-Anordnung ergibt.

Auch hier besteht der Nachteil darin, dass der Druckverlust im Einlauf- bzw. Auslaufbereich, der die Mikrokanäle einer Schicht versorgt, groß ist bzw. sich bei einer Skalierung dieser Anordnung zu höheren Leistungen überproportional erhöht.

Aus der Druckschrift US 4,758,926 ist eine Anordnung bekannt, die zur Kühlung einer Vielzahl von integrierten Schaltkreisen dient. Jedem Schaltkreis ist ein Kühler zugeordnet, der aus einer einzelnen Schicht von Mikrokanälen besteht, die von einem Kühlmedium durchströmt werden.

Auch bei dieser herkömmlichen Lösung ergibt sich natürlich das Problem, dass eine Skalierung dieser Anordnung zu höheren Leistungen die Druckverluste in den Mikrokanälen und den Einlauf- und Auslaufbereichen überproportional ansteigen lässt.

Vor diesem Hintergrund besteht die Aufgabe der vorliegenden Erfindung darin, einen Mikroreaktor anzugeben, dem die vorgenannten Nachteile nicht anhaften und der sich, ohne größere Druckverluste hinnehmen zu müssen, hinsichtlich seiner Leistung skalieren lässt und mit Massenproduktionstechniken herstellbar ist.

Eine Möglichkeit, die der Erfindung zugrunde liegende Aufgabe zu lösen, besteht darin, dass mehrese Mikroreaktorbereiche innerhalb einer Kanalschicht vorgesehen und matrixförmig angeordnet sind, wobei Einlauf- und Auslaufkanäle benachbarter Mikroreaktorbereiche miteinander verbunden sind.

Dass heißt mit anderen Worten, dass mehrere Schichtenstapel Cluster mit jeweils zumindest einer Mikrokanal-Ebene nebeneinander angeordnet werden, wobei dann die Länge der einzelnen Mikrokanäle kürzer ausfallen kann.

Die Einlauf- und Auslaufkanäle benachbarter Schichtenstapel sind hierbei miteinander verbunden bzw. sogar identisch, so dass die Druckverluste auf einem Minimum gehalten werden.

Die vorgenannte Lösung erlaubt es nunmehr, Mikroreaktoren an die unterschiedlichsten Bedingungen bzw. Leistungen anzupassen. So lässt sich die Leistung eines Mikroreaktors durch Erhöhen der Anzahl der Mikrokanal-Ebenen innerhalb eines Clusters oder innerhalb einer matrixförmigen Anordnung gegenüber bisherigen Mikroreaktoren bzw. Wärmetauschern deutlich steigern, ohne die Nachteile eines hohen Druckverlustes in Kauf nehmen zu müssen.

Mithilfe der Clusterung mehrerer Schichten ist es möglich, in den Ein- und Auslaufbereichen die kleinen Kanäle durch große zusammenhängende Bereiche zu ersetzen. Gerade dieses Merkmal führt zu dem vorgenannten Vorteil eines geringen Druckverlusts auch bei einer Skalierung zu höheren Leistungen. Zudem gewinnt man das Volumen des Bodens der einzelnen mit Mikrostrukturen versehenen Schichten für die Ein- und Auslaufbereiche.

Im Hinblick auf die Lösung, mehrere mikrostrukturierte Schichten in der Kanalschicht vorzusehen, kommt es für das Erreichen guter Leistungen darauf an, dass die einzelnen Schichten sehr gut miteinander wärmegekoppelt sind. Das heißt, dass einerseits ein Material verwendet werden muss, das eine hohe Wärmeleitfähigkeit besitzt und zum anderen eine ausreichend große Fläche zur Verfügung stehen muss, die mit der benachbarten Schicht zur Wärmeleitung in Kontakt steht. Hierbei hat sich ein Verhältnis von Mikrokanalbreite zu Stegbreite (Abstand zwischen zwei benachbarten Mikrokanälen) von 2:1 bis 4:1 als besonders vorteilhaft herausgestellt. So liegen die Mirkokanalbreiten vorzugsweise in einem Bereich von 400 bis 800 µm und die Stegbreite bei ca. 200 µm. Ebenfalls vorteilhaft ist eine Kanalbreite von 300 µm und eine Stegbreite von 150 µm. Selbstverständlich sind auch hiervon abweichende Abmessungen denkbar.

Zusammenfassend sei an dieser Stelle nochmals festgehalten, dass die vorgenannte erfindungsgemäße Lösung es ermöglicht, auf Mikrostrukturtechnologie basierende Mikroreaktoren fast beliebig in der Größe skalieren zu können und gleichzeitig den Druckverlust gezielt auf ein Minimum einschränken zu können. Betrachtet man heute den Stand der Technik, so ist bisweilen kein Bauteilkonzept und ein dazu passendes Herstellungsverfahren bekannt, mit dem sich kostengünstige Mikroreaktoren herstellen lassen, weshalb diese Technologie beispielsweise in der Automobilindustrie oder in der Computerindustrie keine Anwendung findet.

Ein besonderer Vorteil der erfindungsgemaßen Lösung besteht darin, dass sie einfach und kostengünstig herstellbare Mikrostrukturen enthalten, die sich z.B. mittels üblicher aus dem Halbleiterbereich bekannter Verfahren erzeugen lassen, und mit denen sich gleichzeitig extrem leistungsfähige Bauteile realisieren lassen. Die Massenproduktion von mikrostrukturierten Bauteilen wird daher erstmals möglich.

In einer bevorzugten Weiterbildung sind die einzelnen Schichten der Kanalschicht gleich ausgebildet. Diese Maßnahme hat den Vorteil, dass eine besonders kostengünstige Fertigung möglich ist.

In einer bevorzugten Weiterbildung sind die einzelnen Schichten der Kanalschicht zueinander ausgerichtet angeordnet, so dass die Mikrokanäle bzw. die Stege zwischen den Mikrokanälen der einzelnen Schichten übereinander liegen.

Diese Maßnahme hat den Vorteil, dass eine besonders gute Wärmeleitung von einer Schicht zur nächsten über die mit der benachbarten Schicht in Kontakt stehenden Stege möglich ist.

In einer bevorzugten Weiterbildung weist die Kanalschicht eine Vielzahl der einzelnen Schichten auf, wobei vorzugsweise die Mikrokanäle der einzelnen Schichten parallel zueinander verlaufen.

Abhängig von dem jeweiligen Anwendungsfall lassen sich bspw. bis zu 20 einzelne Schichten übereinander zu einem Cluster stapeln, so dass eine entsprechende Anzahl von Mikrokanal-Ebenen bereit gestellt wird. Ein Parameter zur Bestimmung der Anzahl der zusammengefassten Schichten ist die Wärmeleitfähigkeit des Materials der Schichten und des eingesetzten Mediums. Bei Gasen kann es beispielsweise sinnvoll sein, 10 bis 20 Schichten als Cluster zusammenzufassen. Bei einer Flüssigkeit als Medium können auch mehr Schichten vorgesehen sein. Andererseits kann es bei einem schlechter als Kupfer oder Aluminium wärmeleitenden Material wie Edelstahl als Schichtmaterial sinnvoll sein, beispielsweise nur zwei bis sieben Schichten zusammenzufassen.

In einer bevorzugten Weiterbildung werden die Mikrostrukturen durch Ätzen hergestellt, wobei sich dadurch ein halbelliptischer Querschnitt der einzelnen Mikrostrukturen ergibt.

Diese Maßnahme hat nicht nur den Vorteil, dass eine sehr kostengünstige Herstellung mit den aus dem Halbleiterbereich bekannten Verfahren möglich ist, sondern dass gerade die sich durch das Ätzen ergebende nicht rechteckige Querschnittsform der Mikrokanäle unter strömungstechnischen Gesichtspunkten sehr günstig ist. Das heißt mit anderen Worten, dass durch Ätzen hergestellte Mikrokanäle einen geringeren Strömungswiderstand besitzen als beispielsweise rechteckförmige Kanäle.

In einer bevorzugten Weiterbildung sind die Mikrostrukturen durch Prägen hergestellt, so dass sich im wesentlichen ein prägetypischer, bspw. rechteckiger oder trapezförmiger Querschnitt ergibt.

Das Prägen von Mikrostrukturen hat gegenüber dem vorgenannten Ätzen nochmals deutliche Vorteile, insbesondere unter Kostengesichtspunkten, da unter anderem der Bearbeitungsaufwand geringer wird.

In einer bevorzugten Weiterbildung sind zumindest zwei Kanalschichten aufeinander angeordnet und bilden einen Schichtenblock, wobei jede Kanalschicht einen eigenen Einlauf- und Auslaufkanal aufweist, so dass die Kanalschichten des Schichtenblocks mit unterschiedlichen Medien durchströmbar sind.

Das heißt mit anderen Worten, dass der Mikroreaktor einen Schichtenstapel mit zumindest zwei Kanalschichten aufweist, wobei jede Kanalschicht einen eigenen Einlauf- und Auslaufkanal umfasst, so dass die eingesetzten Kanalschichten mit unterschiedlichen Medien durchströmbar sind. Damit wäre also eine Vorrichtung realisierbar, die Wärme von einem Medium auf ein anderes Medium überträgt. Dabei ist selbstverständlich wiederum von Bedeutung, dass nicht nur die einzelnen Schichten einer Kanalschicht, sondern auch die beiden Kanalschichten selbst, gut miteinander wärmegekoppelt sind, so dass eine optimale Wärmeleitung erreicht wird.

Werden die Kanalschichten so angeordnet, dass die Mikrokanäle der beiden Kanalschichten zueinander um 90° versetzt verlaufen, lässt sich eine Kreuzstrom-Anordnung mit sehr gutem Wirkungsgrad aufbauen. Selbstverständlich können die beiden Kanalschichten auch als Gleichstrom- oder Gegenstromüberträger beschrieben werden.

In einer bevorzugten Weiterbildung sind mehrere Schichtenstapel in einer Reihe nebeneinander angeordnet. Vorzugsweise sind die mehreren Schichtenstapel matrixförmig angeordnet.

Wie bereits zuvor erläutert, stellt die matrixförmige Anordnung eine Lösung dar, dem Druckverlust bei einer Skalierung zu höheren Leistungen entgegenzuwirken. Diese Lösung lässt sich vorteilhafterweise auch mit der eingangs genannten Lösung der Clusterbildung kombinieren.

In einer bevorzugten Weiterbildung ist zumindest ein Abstands- und Verbindungsmittel (nachfolgend kurz Verbindungsmittel genannt) zwischen zwei einzelnen Schichten der Kanalschicht vorgesehen, um die beiden Schichten miteinander zu verbinden und den Querschnitt der Mikrokanäle zu vergrößern.

Diese Maßnahme führt zu dem Vorteil, dass einem Druckverlust durch Erhöhung des Strömungswiderstands der Mikrokanäle entgegengewirkt werden kann. Darüber hinaus wird die Verbindung zwischen zwei einzelnen Schichten der Kanalschicht bzw. einer einzelnen Schicht und der Deckschicht einfacher und kostengünstiger.

Üblicherweise werden die einzelnen Schichten der Kanalschicht mithilfe von Lötverfahren etc. miteinander verbunden. Dabei wird auf die Oberfläche der zu verbindenden Schichten ein Lot aufgetragen, dass zumindest einen teuren Bestandteil, bspw. Silber enthält. Da das Verbindungsmittel eine geringere Oberfläche besitzt als die einzelne Schicht selbst, kann teures Lot eingespart werden. Eine besonders hohe Einsparung lässt sich dann erreichen, wenn das Verbindungsmittel ein beschichteter Draht ist, der die Mikrostruktur umgibt, so dass das Medium in den Mikrokanälen bleibt. Bei diesem vorteilhaften Ausführungsbeispiel muss nur die gegenüber der Oberfläche der einzelnen Schicht geringere Oberfläche des Drahts mit dem Lot versehen werden.

Wie bereits erwähnt, haben die Mikrokanäle bevorzugt eine Breite im Bereich von 400 µm, eine Tiefe von 200 µm und eine Länge von 8 bis 20 mm. Der Abstand benachbarter Mikrokanäle einer einzelnen Schicht liegt im Bereich von 200 bis 300 µm, so dass die zwischen zwei Mikrokanälen ausgebildeten Stege eine Breite von 200 bis 300 µm aufweisen.

Wie ebenfalls zuvor angedeutet, kommt den Stegen der einzelnen Schichten einer Kanalschicht bei der Wärmeübertragung zwischen den einzelnen Schichten große Bedeutung zu, so dass die Kontaktfläche der Stege zu benachbarten Schichten nicht zu gering sein darf.

In einer bevorzugten Weiterbildung ist der Mikroreaktor als Kühler für ein elektronisches Bauelement ausgebildet, wobei die der Mikrostruktur abgewandte Fläche der Kanalschicht mit dem Bauelement thermisch koppelbar ist.

Die Erfinder haben festgestellt, dass ein erfindungsgemäß aufgebauter Mikroreaktor außerordentlich gute Ergebnisse bei der Kühlung von elektronischen Bauelementen liefert.

In einer bevorzugten Weiterbildung ist die Fläche zur thermischen Kopplung mit einem elektronischen Bauelement mit einer Mikrostruktur versehen.

Dies hat den Vorteil, dass die Mikrostrukturen ein Abfließen oder Verdrängen von Hilfsstoffen ermöglichen, die zur Kontaktierung des Mikroreaktors mit dem zu temperierenden Bauteil oder Oberfläche verwendet werden. Hierbei handelt es sich beispielsweise um Wärmeleitpasten, Lote etc. Diese Hilfsstoffe besitzen in der Regel eine erheblich schlechtere Wärmeleitfähigkeit als das Material des Mikroreaktors.

In einer bevorzugten Weiterbildung sind mehrere Schichtenstapel kreisförmig angeordnet.

Das heißt mit anderen Worten, dass statt einer rechteckigen matrixförmigen Anordnung eine kreisförmige Anordnung ebenfalls denkbar ist. Es versteht sich, dass daneben natürlich auch andere Formen der Anordnung möglich sind.

Weiter bevorzugt ist es, dass ein Bypass vorgesehen ist, um das Medium unter teilweiser oder vollständiger Umgehung der Mikrokanäle vom Einlaufkanal zum Auslaufkanal zu führen.

Die vorgenannten Maßnahmen haben den Vorteil, dass der Mikroreaktor auch bei Anwendungen einsetzbar ist, bei denen Wärme zwischen Fluiden mit verschiednen Viskositäten übertragen werden soll und unterschiedliche Druckverluste zulässig sein sollen. Hierbei kann man dann die Kanallängen entsprechend unterschiedlich lang gestalten. Es lässt sich zum Beispiel durch eine kreisförmige Anordnung die Zu- und Abfuhr für jeweils ein Fluid sehr vorteilhaft gestalten. Als Beispiel kann ein als Wärmeübertrager dienender Mikroreaktor für Wasser und Öl genannt werden, wie er im Motorenbau vorkommt. Darüber hinaus lässt sich durch die kreisförmige Anordnung der genannte Bypass sehr leicht realisieren. Ein solcher bspw. als Blende ausgebildeter Bypass ist oft notwendig, um unter extremen Temperaturbedingungen den Durchfluss eines Mediums auch in einem zähflüssigen Zustand, beispielsweise Öl, sicherzustellen. Der Bypass hat darüber hinaus den Vorteil, dass im Falle von Öl dieses immer stärker durch die Mikrokanäle strömt je wärmer es wird, so dass bei ansteigender Temperatur das Öl verstärkt über die Mikrokanäle gekühlt werden kann.

In einer bevorzugten Weiterbildung sind Hohlräume zwischen einzelnen Schichtenstapel vorgesehen, um eine thermische Entkopplung vorzusehen.

Ferner ist bevorzugt, die Schichten aus unterschiedlichen Materialien, beispielsweise Metall, Kunststoff, etc., herzustellen, was den Vorteil bietet, dass eine noch bessere Anpassung an die jeweilige Gegebenheit möglich ist.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Weitere Vorteile und Ausgestaltungen der Erfindung ergeben sich aus der Beschreibung der beiliegenden Zeichnungen. Die Erfindung wird nachfolgend anhand von verschiedenen Ausführungsbeispielen mit Bezug auf die Zeichnung näher erläutert. Dabei zeigen:
- Fig. 1a: eine einzelne Schicht, deren eine Oberfläche mit einer Mikrostruktur versehen ist;
- Fig. 1b: eine einzelne Schicht, bei der zwei gegenüberliegende Oberflächen mit einer Mikrostruktur versehen sind;
- Fig. 1c: eine schematische Schnittdarstellung eines Stapels aus übereinander liegenden einzelnen mikrostrukturierten Schichten zur Erläuterung des allgemeinen Aufbaus eines Mikroreaktors;
- Fig. 2a: eine schematische Schnittdarstellung zweier übereinanderliegender mikrostrukturierter Schichten mit Abstandshalter;
- Fig. 2b: schematische Darstellungen der Abstandhalter in Draufsicht;
- Fig. 2c: eine schematische Schnittansicht eines Stapels aus zwei einzelnen Schichten mit einem Abstandshalter gemäß einer zweiten Ausführungsvariante;
- Fig. 3a: eine schematische Darstellung eines Stapels einzelner Schichten für zwei unterschiedliche Medien mit den zugehörigen Einlauf- und Auslaufbereichen;
- Fig. 3b: eine schematische Darstellung mehrerer matrixförmig verschalteter Stapel einzelner Schichten entsprechend Fig. 3a;
- Fig. 3c+d: schematische Darstellungen der matrixförmigen Anordnung gemäß Fig. 3b mit schematisch eingezeichneten Verbindungskanälen zur Versorgung der einzelnen Einlauf- und Auslaufbereiche;
- Fig. 4a: eine schematische Darstellung mehrerer matrixförmig angeordneter Stapel einzelner Schichten für ein Medium;
- Fig. 4b: eine schematische Schnittansicht einer Anordnung mehrerer Stapel einzelner Schichten für zwei Medien;
- Fig. 5: eine isometrische schematische Darstellung des Aufbaus eines Mikroreaktors mit mehreren Schichten;
- Fig. 5b: eine perspektivische Darstellung des in Fig. 5a gezeigten Mikroreaktors mit geschlossenem Gehäuse;
- Fig. 6a-i: schematische Darstellungen einzelner Schichten eines Mikroreaktors in Draufsicht;
- Fig. 7: eine schematische Schnittdarstellung eines Mikroreaktors;
- Fig. 8: eine schematische Schnittdarstellung eines Reaktors zur Temperierung eines Bauteils mithilfe mehrerer Fluide;
- Fig. 9: eine isometrische Darstellung eines Mikroreaktors mit einer Vielzahl von matrixförmig angeordneten Stapeln einzelner Schichten;
- Fig. 10a,b: eine schematische Draufsicht bzw. eine Schnittdarstellung eines Mikroreaktors, der aus ringförmig angeordneten Clustern einzelner Schichten besteht;
- Fig. 11a,b: eine schematische Draufsicht bzw. Schnittdarstellung eines Mikroreaktors gemäß Fig. 10 mit einem Bypass;
- Fig. 12: eine schematische Schnittdarstellung eines Kühlers für ein elektronisches Bauelement mit den einzelnen Schichten in Draufsicht;
- Fig. 13: eine schematische Schnittdarstellung eines weiteren Kühlers für ein elektronisches Bauelement mit den zugehörigen Schichten in Draufsicht;
- Fig. 14: eine schematische Darstellung eines Kühlers in Draufsicht und in einer Schnittansicht;
- Fig. 15: eine schematische Schnittdarstellung eines Stapels einzelner Schichten mit einem zu temperierenden Bauteil;
- Fig. 16: eine schematische Schnittdarstellung eines Kühlers für ein elektronisches Bauelement, der aus mehreren Stapeln einzelner Schichten aufgebaut ist;
- Fig. 17a-f: eine schematische Darstellung eines Kühlers für elektronische Bauelemente in verschiedenen Ansichten, der vier Mikroreaktor-Bereiche aufweist; und
- Fig. 18: eine schematische Darstellung eines Kühlers für elektronische Bauelemente in verschiedenen Ansichten, der zwei Mikroreaktor-Bereiche aufweist.

In den genannten Zeichnungen sind unterschiedliche Möglichkeiten dargestellt, einen Mikroreaktor aufzubauen. All diesen Lösungen ist gemein, dass sie mikrostrukturierte Schichten verwenden, um Mikrokanäle zu schaffen. Diese Mikrokanäle dienen dazu, ein Medium (gasförmig oder flüssig) zu führen, wobei dabei ein Austausch von Energie zwischen dem Medium und den Wänden der Mikrokanäle stattfindet. Unter dem Begriff "Mikroreaktor" sind somit nicht nur chemische Reaktoren zu verstehen, in denen chemische Reaktionen ablaufen, sondern auch Wärmetauscher, die Energie zwischen zwei Medien austauschen, und beispielsweise Erhitzer oder Kühler zur Temperierung von Bauteilen.

Darüber hinaus ist unter dem Begriff "Mikrostruktur" eine Struktur zu verstehen, die zumindest in einer Dimension < 1 mm ist.

Schließlich sei vorab noch angemerkt, dass die nachfolgend erläuterten Lösungen alle miteinander kombinierbar sind, selbst wenn dies nicht explizit erläutert bzw. in den Zeichnungen gezeigt ist.

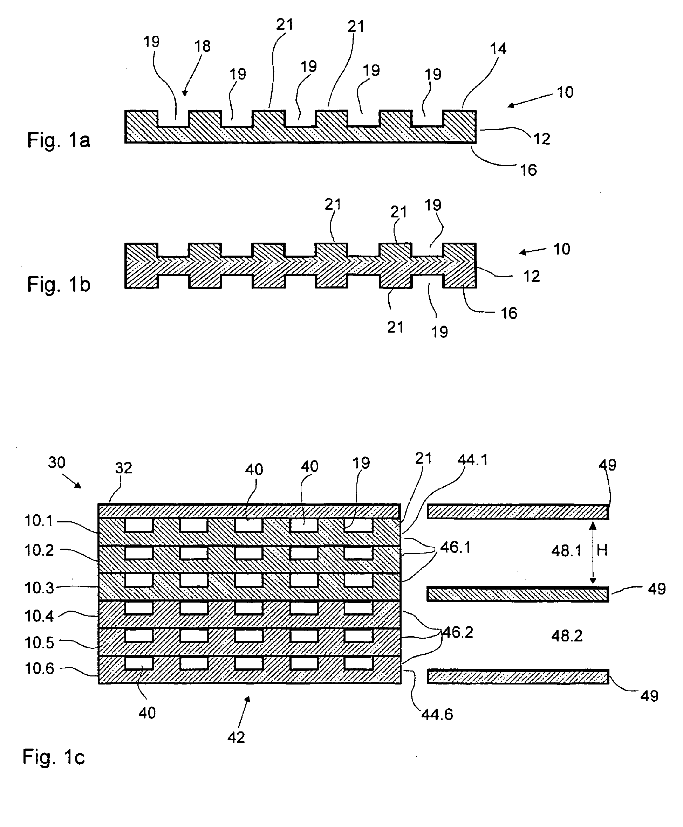

In Fig. 1a ist eine einzelne mikrostrukturierte Schicht schematisch in einer Schnittdarstellung gezeigt und mit dem Bezugszeichen 10 gekennzeichnet. Bei dieser mikrostrukturierten Schicht 10 handelt es sich beispielsweise um eine dünne Metallfolie 12 mit einer ersten Oberfläche 14 und einer zweiten Oberfläche 16. In die erste Oberfläche 14 sind Mikrostrukturen 18 eingebracht, wobei diese Mikrostrukturen 18 im vorliegenden Ausführungsbeispiel als geradlinige parallel zueinander verlaufende Vertiefungen bzw. Nuten ausgebildet sind. In der Fig. 1a sind diese Vertiefungen im Querschnitt rechteckförmig dargestellt. Dies ist jedoch rein beispielhaft und entspricht nicht notwendigerweise der tatsächlichen Querschnittsform, die sich im wesentlichen durch das verwendete Herstellungsverfahren ergibt.

Um derartige mikrostrukturierte Schichten 10 in großem Maßstab herzustellen, werden üblicherweise Verfahren aus dem Halbleiterbereich eingesetzt, wie beispielsweise das chemische Ätzen. Bei diesem Verfahren ergeben sich üblicherweise Vertiefungen mit einem halbelliptischen Querschnitt. Darüber hinaus lassen sich mit diesem Ätzverfahren nur Vertiefungen herstellen, die breiter sind als tief. Dies stellt eine gewisse Einschränkung dar, da die Übertragung von Energie zwischen Medium und Schicht über die zwischen den Vertiefungen 19 liegenden Stegen 21 erfolgt. Aus diesem Grund wäre es sehr viel vorteilhafter, schmale und dafür tiefe Vertiefungen 19 herzustellen.

Ein möglicher Weg, solche optimierten Vertiefungen herzustellen, besteht darin, diese Vertiefungen in die Metallfolie zu prägen. Selbstverständlich sind auch andere Herstellungsverfahren denkbar, um derartige Vertiefungen 19 in eine dünne Schicht einzubringen. Darüber hinaus versteht sich, dass die mikrostrukturierte Schicht 10 nicht nur aus einer gut wärmeleitenden Metallfolie, bspw. aus Kupfer, Aluminium oder Edelstahl, sondern auch aus einer Kunststofffolie, Keramikfolie oder anderen Materialien gefertigt werden kann.

Die sich in der Praxis als vorteilhaft herausgestellten Dimensionen solcher Vertiefungen sind beispielsweise 400 µm breit, 200 µm tief und 8 bis 20 mm lang. Der Abstand zweier benachbarter Vertiefungen liegt im Bereich von 200-300 µm, so dass die Breite der Stege 21 also 200-300 µm beträgt.

In Fig. 1a ist noch zu erkennen, dass die zweite Oberfläche 16 eben, d.h. nicht mit einer Mikrostruktur versehen, ist.

Wie in Fig. 1b dargestellt ist es jedoch auch möglich, diese zweite Oberfläche 16 mit einer entsprechenden Mikrostruktur 18 zu versehen, so dass auf beiden Oberflächen 14, 16 Vertiefungen und Stege ausgebildet sind. In dem in Fig. 1b gezeigten Beispiel sind die beiden Mikrostrukturen 18 identisch ausgebildet, wobei Vertiefungen 19 und Stege 21 einander gegenüber liegen. Es ist jedoch auch denkbar, die beiden Oberflächen 14, 16 mit unterschiedlichen Mikrostrukturen 18 zu versehen.

Wie eingangs bereits angedeutet, wird ein Mikroreaktor aus einzelnen mikrostrukturierten Schichten 10 aufgebaut. In Fig. 1c ist ein Ausschnitt eines solchen Mikroreaktors schematisch in einer Schnittdarstellung gezeigt und mit dem Bezugszeichen 30 gekennzeichnet. Typischerweise umfasst ein Mikroreaktor 30 eine Deckschicht 32 und mehrere, im vorliegenden Beispiel insgesamt sechs mikrostrukturierte Schichten 10, die in Fig. 1c zur besseren Verständlichkeit mit einer laufenden Nummer versehen sind (10.1 bis 10.6). Alle mikrostrukturierten Schichten 10, 1-10, 6 sind identisch zueinander ausgebildet und so zueinander angeordnet, dass die Stege 21 der einzelnen Schichten 10 übereinander liegen.

Die Vertiefungen 19 der ersten mikrostrukturierten Schicht 10.1 werden von der Deckschicht 32 abgedeckt, so dass geschlossene Mikrokanäle 40 gebildet werden. Obgleich in Fig. 1c die Deckschicht 32 auf allen Stegen 21 der mikrostrukturierten Schicht 10.1 aufliegt und damit die Mikrokanäle 40 abdichtet, ist es durchaus auch akzeptabel, wenn benachbarte Mikrokanäle 40 über einen Spalt zwischen Deckschicht und Steg in Verbindung stehen, sofern gewährleistet ist, dass die Deckschicht 32 zumindest am Rand dicht auf der mikrostrukturierten Schicht 10.1 aufliegt.

Auch in den darunter liegenden mikrostrukturierten Schichten 10.2-10.6 werden Mikrokanäle 40 ausgebildet, wobei die jeweiligen Vertiefungen 19 dann von der zweiten Oberfläche 16 der darüber liegenden Schicht 10 analog zu der Deckschicht 32 geschlossen werden.

Damit ergibt sich ein Stapel 42 einzelner Schichten 10, 32, der mehrere Mikrokanal-Ebenen 44.1 bis 44.6 aufweist.

Die einzelnen Schichten 10, 32 werden üblicherweise durch Löten oder Schweißen miteinander verbunden. Andere Herstellungs- bzw. Fügeverfahren sind selbstverständlich auch denkbar. Das Löten hat sich jedoch im Hinblick auf eine Massenproduktion als besonders vorteilhaft herausgestellt.

Die Mikrokanäle 40 eines solchen Mikroreaktors 30 werden mit einem oder mehreren Medien durchströmt, wobei hierfür den Mikrokanälen vorgelagerte Einlaufbereiche bzw. Einlaufkanäle und den Mikrokanälen nachgeordnete (in Strömungsrichtung gesehen) Auslaufbereiche bzw. Auslaufkanäle vorgesehen sind.

Um nun die Druckverluste in diesen Einlauf- und Auslaufbereichen zu minimieren, werden mehrere einzelne mikrostrukturierte Schichten 10 zu einem sogenannten Cluster zusammengefasst und über einen gemeinsamen Einlaufbereich bzw. Auslaufbereich versorgt. In dem in Fig. 1c gezeigten Beispiel sind die drei oberen mikrostrukturierten Schichten 10.1, 10.2 und 10.3 zu einem Cluster 46.1 zusammengefasst und die darunter liegenden mikrostrukturierten Schichten 10.4, 10.5 und 10.6 zu einem zweiten Cluster 46.2. Damit erstreckt sich der Einlaufbereich bzw. der Auslaufbereich eines Clusters über die Höhe von annähernd drei Schichten, wie dies in Fig. 1c durch den Buchstaben H angedeutet ist. Der schematisch angedeutete Einlaufbereich 48 wird durch schematisch dargestellte Schichten 49 begrenzt, so dass sich zwei Einlaufbereiche 48.1 und 48.2, die jeweils einem Cluster 46.1 bzw. 46.2 zugeordnet sind, ergeben.

Mithilfe dieser Zusammenfassung mehrerer einzelner Schichten 10 zu einem Cluster 46 und die Versorgung über einen gemeinsamen Einlaufbereich bzw. Auslaufbereich erreicht man den Vorteil, dass der hydraulische Durchmesser für das durchströmende Fluid steigt und damit dessen Geschwindigkeit sinkt, so dass sich der Druckverlust in diesem Bereich erheblich reduziert. Durch das Zusammenfassen mehrerer Schichten werden in den Einlauf- bzw. Auslaufbereichen die kleinen Mikrokanäle 40 durch große zusammenhängende Bereiche 48 ersetzt. Zudem gewinnt man das Volumen des Bodens der strukturierten Schichten für die Einlauf- und Auslaufbereiche.

Im vorliegenden Beispiel ist der Mikroreaktor 30 für zwei unterschiedliche Fluide ausgelegt, da die mikrostrukturierten Schichten 10 zu zwei Clustern 46.1 und 46.2 mit jeweils eigenen Einlauf- und Auslaufbereichen 48.1 und 48.2 zusammengefasst sind.

Die angegebene Zahl von drei Schichten pro Cluster ist rein beispielhaft gewählt und kann zu kleineren als auch zu größeren Zahlen hin verändert werden. Die minimale Anzahl von einzelnen mikrostrukturierten Schichten 10 pro Cluster ist zwei, eine obere Grenze besteht jedoch nicht. In der Praxis haben sich jedoch 5 bis 20 zu einem Cluster 46 zusammengefasste mikrostrukturierte Schichten 10 als vorteilhaft herausgestellt.

Darüber hinaus sei an dieser Stelle angemerkt, dass ein Mikroreaktor 30 auch so ausgelegt sein kann, dass nur ein Medium strömt, was in Bezug auf das in Fig. 1c gezeigte Beispiel zur Folge hätte, dass alle mikrostrukturierte Schichten 10.1 bis 10.6 zu einem Cluster 46 zusammengefasst werden, der von einem gemeinsamen, sich über die gesamte Höhe des Stapels 42 erstreckenden Einlauf- bzw. Auslaufbereichs 48 versorgt werden würde. Die in Fig. 1c dargestellte mittlere Schicht 49 im Einlaufbereich 48 würde folglich wegfallen.

Darüber hinaus sei an dieser Stelle angemerkt, dass die Anzahl der zu Clustern zusammengefassten mikrostrukturierten Schichten nicht gleich sein muss. Die Anzahl der zusammengefassten Schichten pro Cluster wird vielmehr danach ausgewählt, welches Medium die entsprechenden Mikrokanäle durchströmt. So kann es bei einem als gasbeheizten Verdampfer dienenden Mikroreaktor 30 z.B. sinnvoll sein, 10 Schichten für das Gas mit 1 bis 3 Schichten für das zu verdampfende Medium zu kombinieren. Mit der gezeigten Clusterung von Schichten lässt sich folglich der Druckverlust und der Massendurchsatz für jedes Medium in weiten Bereichen einstellen, was bei der bisherigen Mikrostrukturtechnologie schwer oder nicht möglich war.

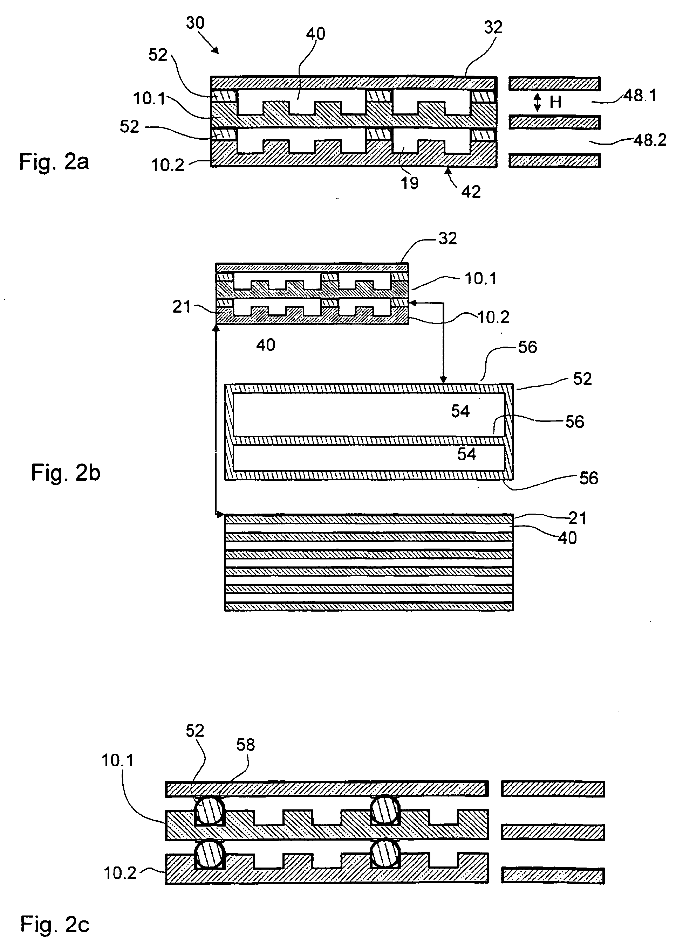

In Fig. 2a ist eine weitere Lösung schematisch dargestellt, wie Mikroreaktoren optimiert werden können.

Der in Fig. 2a gezeigte Mikroreaktor 30 umfasst zwei einzelne mikrostrukturierte Schichten 10.1 und 10.2 und eine Deckschicht 32, die einen Stapel 42 bilden. Die mikrostrukturierten Schichten 10.1 und 10.2 entsprechen den mit Bezug auf Fig. 1a bereits erläuterten Schicht 10, so dass auf eine nochmalige Beschreibung verzichtet werden kann. Im Gegensatz zu dem in Fig. 1c gezeigten Stapel einzelner Schichten liegen bei dieser Ausführungsform die einzelnen Schichten 10.1 und 10.2 nicht direkt aufeinander, sondern sind über Abstandshalter 52 miteinander verbunden.

Wie in Fig. 2b zu erkennen, handelt es sich bei dem Abstandshalter 52 um eine Schicht, beispielsweise eine Metallfolie, die große Aussparungen 54 besitzt. Derartige Aussparungen lassen sich beispielsweise durch Stanzen der Metallfolie herstellen. Die Aussparungen 54 sind so gewählt, dass der Abstandshalter 52 in der Art eines Rahmens mehrere miteinander verbundene Stege 56 aufweist. Die Platzierung bzw. Ausbildung dieser Stege 56 erfolgt so, dass sie, wie in Fig. 2a zu erkennen ist, auf Stegen 21 der entsprechenden mikrostrukturierten Schicht 10 aufliegen. Dabei müssen die Stege 56 jedoch nicht auf jedem der Stege 21 aufliegen. In dem in Fig. 2a gezeigten Beispiel liegen zwischen zwei benachbarten Stegen 56 einmal drei und einmal zwei Vertiefungen 19. Wichtig bei der Ausgestaltung des Abstandshalters 52 ist lediglich, dass auf den äußeren Stegen 21 der mikrostrukturierten Schichten 10 Stege 56 des Abstandshalters 52 liegen, um eine Abdichtung nach außen zu erreichen.

Der Vorteil der verwendeten Abstandshalter 52 liegt darin, dass die freie Oberfläche, die zur Wärmeübertragung verfügbar ist, nahezu verdoppelt werden kann. Zudem lässt sich der freie Querschnitt für das durchströmende Medium vergrößern, ohne dass sich die Wärmeübertragungsleistung erheblich reduziert. Zudem vergrößert sich die Höhe H der im Beispiel gezeigten beiden Einlaufbereiche 48.1 und 48.2 (dann natürlich auch der Auslaufbereiche), so dass auch hiermit eine Senkung der Druckverluste möglich wird.

Ein weiterer Vorteil lässt sich mit den Abstandshaltern 52 dann erreichen, wenn die einzelnen Schichten mittels Lotverfahren miteinander verbunden werden. Da das üblicherweise silberhaltige und damit teure Lot nur auf die Abstandshalter 52 aufgetragen werden muss, kommt man mit einer deutlich geringeren Lotmenge aus als bei dem in Fig. 1c gezeigten Reaktor.

An dieser Stelle sei angemerkt, dass diese Lösung zur Optimierung von Mikroreaktoren sowohl alleine als auch in Kombination mit der zuvor beschriebenen Clusterung realisierbar ist. In dem in Fig. 2a gezeigten Beispiel ist z.B. eine Zusammenfassung mehrerer Schichten zu einem Cluster nicht vorgesehen.

In Fig. 2c ist eine weitere Möglichkeit dargestellt, wie Abstandshalter 52 ausgestaltet sein können. In dem gezeigten Beispiel sind die Abstandshalter 52 als Drähte 58 ausgeführt, die in Vertiefungen 19 der mikrostrukturierten Schichten 10.1 bzw. 10.2 liegen. Die Funktionsweise dieser Abstandshalterdrähte ist jedoch identisch zu den plattenförmigen Abstandshaltern, wie sie in Fig. 2b dargestellt sind. Der Vorteil von Drähten liegt insbesondere darin, dass sie unabhängig von der endgültigen Form des resultierenden Mikroreaktors beschichtet werden können, um sie z.B. in Rollen später bereitzustellen. Die Schichten müssen bei dieser Variante nicht unbedingt selbst Kanalstrukturen aufweisen, da die Kanäle alleine durch die Abstandshalter 58 entstehen können. Dieser Typ von Abstandshalter kann vorzugsweise mit einer Bondingtechnik auf die Schichten aufgebracht werden, so dass es möglich ist, beliebige Strukturen zu realisieren.

Als Alternative zu den vorbeschriebenen Abstandshaltern lassen sich auch die mikrostrukturierten Schichten 10 selbst auf beiden Seiten mit unterschiedlichen Strukturen versehen, z.B. durch Ätzen oder Prägen, um vergleichbare Querschnitte zu erzielen.

Das heißt mit anderen Worten, dass beispielsweise die zweite Oberfläche 16 der ersten mikrostrukturierten Schicht 10.1 mit entsprechenden Aussparungen 54 - wie in Fig. 2b gezeigt - versehen wird. Auch hiermit wäre eine Vergrößerung des Querschnitts der Mikrokanäle 40 möglich.

Eine weitere Alternative stellen tiefgezogene, gewalzte, gefaltete oder geprägte Schichten dar.

Mit den zuvor genannten Lösungen lassen sich die Druckverluste innerhalb eines Mikroreaktors erheblich verringern, so dass die Leistungsdichte des Mikroreaktors gesteigert wird.

Da für eine weitere Erhöhung der Leistungsdichten weder die Anzahl der zusammengefassten Schichten beliebig erhöht noch die Kanallängen beliebig verlängert werden können, haben die Erfinder eine Lösung geschaffen, mit der eine weitere Leistungserhöhung zu realisieren ist. Diese nachfolgend beschriebene Lösung kann sowohl in Kombination mit den zuvor beschriebenen Lösungen (Clusterung, Abstandshalter) als auch alleine zum Einsatz kommen.

Die Grundidee dieser Lösung besteht darin, die Mikrokanäle 40 zu segmentieren, wobei zwischen den segmentierten Mikrokanälen gemeinsame Bereiche (Einlauf- bzw. Auslaufbereiche) vorgesehen werden. Das heißt mit anderen Worten, dass ein Mikroreaktor quasi in mehrere kleine Mikroreaktoren, die miteinander verschaltet sind, untergliedert wird.

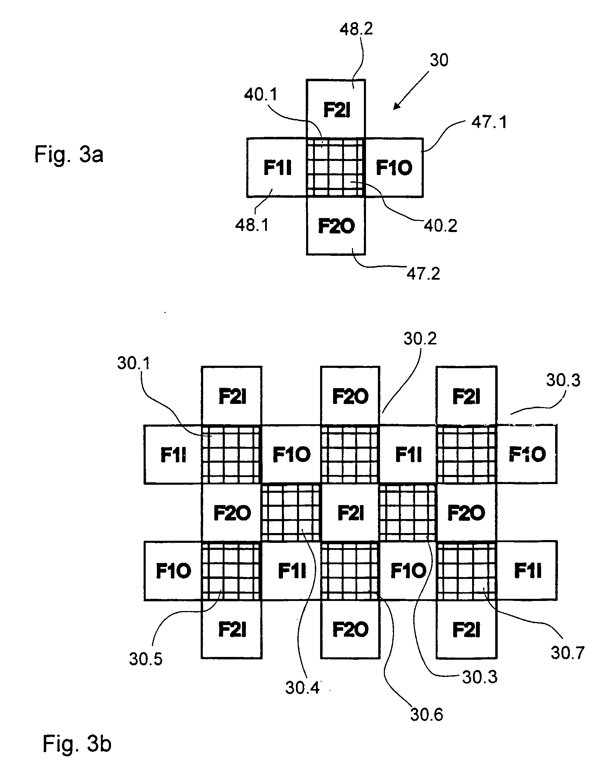

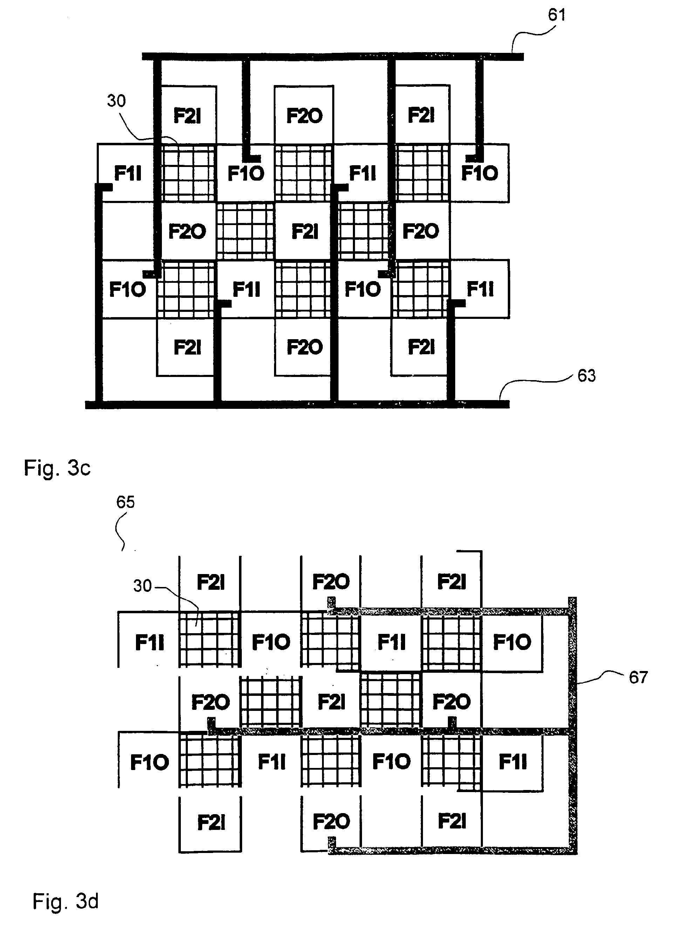

Anhand der Fig. 3 bis 7 soll dieses Prinzip nun nachfolgend detailliert erläutert werden.

Ausgangspunkt ist ein Mikroreaktor 30, wie er beispielsweise in Fig. 1c gezeigt. Dieser für zwei Fluide F1, F2 ausgelegte Mikroreaktor 30 ist in Fig. 3a in Draufsicht dargestellt, wobei die Mikrokanäle 40 des zweiten Clusters 46.2 um 90° zu den Mikrokanälen 40 des ersten Clusters 46.1 verdreht sind, so dass sich eine Kreuzstrom-Anordnung ergibt. In Fig. 3a sind die Mikrokanäle schematisch dargestellt und mit den Bezugszeichen 40.1 und 40.2 gekennzeichnet. Die Mikrokanäle 40.1 gehören zu dem Cluster 46.1 und die Mikrokanäle 40.2 zu dem zweiten Cluster 46.2.

Ferner sind in Fig. 3a die Einlauf- und Auslaufbereiche der beiden Cluster dargestellt und mit den Bezugszeichen 48.1, 48.2 bzw. 47.1 und 47.2 gekennzeichnet. Die zusätzlich verwendete Kennzeichnung F1I steht ein Fluid 1 Einlauf, F10 für Fluid 1 Auslauf, F2I für Fluid 2 Einlauf und F2O für Fluid 2 Auslauf.

In Fig. 3b ist nun eine Anordnung gezeigt, die eine Vielzahl der in Fig. 3a dargestellten Mikroreaktoren 30 umfasst. Die einzelnen Mikroreaktoren 30 sind matrixförmig, d.h. in Linien und Spalten, angeordnet, wobei benachbarte Mikroreaktoren Einlauf- und Auslaufbereiche miteinander teilen. Das heißt im günstigsten Fall, dass Einlauf- und Auslaufbereiche benachbarter Mikroreaktoren identisch sind.

Beispielsweise ist der Auslaufbereich für das zweite Fluid F2O des Mikroreaktors 30.4 identisch zu den Auslaufbereichen F2O der benachbarten Mikroreaktoren 30.1 und 30.5.

Insgesamt ist festzustellen, dass mithilfe dieser matrixförmigen Anordnung jeweils ein Einlauf- bzw. Auslaufbereich von insgesamt vier Mikroreaktoren genutzt werden kann, so dass eine Verteilung bzw. Sammlung der Medien einfach möglich ist. Diese matrixförmige Anordnung, wie sie in Fig. 3b gezeigt ist, lässt sich im wesentlichen beliebig vergrößern, indem weitere Mikroreaktoren (mit verkürzter Mikrokanallänge) hinzugeschaltet werden.

In Fig. 3c ist eine Möglichkeit dargestellt, wie die Einlauf- und Auslaufbereiche für das erste Fluid (F1I und F1O) über Kanäle 61 bzw. 63 verschaltet, d.h. verbunden, sein können.

In Fig. 3d ist eine gleiche Darstellung gezeigt, in der die Verschaltung bzw. Verbindung der Einlauf- und Auslaufbereiche des zweiten Fluids F2I, F20 über Kanäle 65 bzw. 67 vorgenommen wird. Selbstverständlich sind auch andere Verschaltungen, beispielsweise über jeweils getrennte Kanäle, möglich.

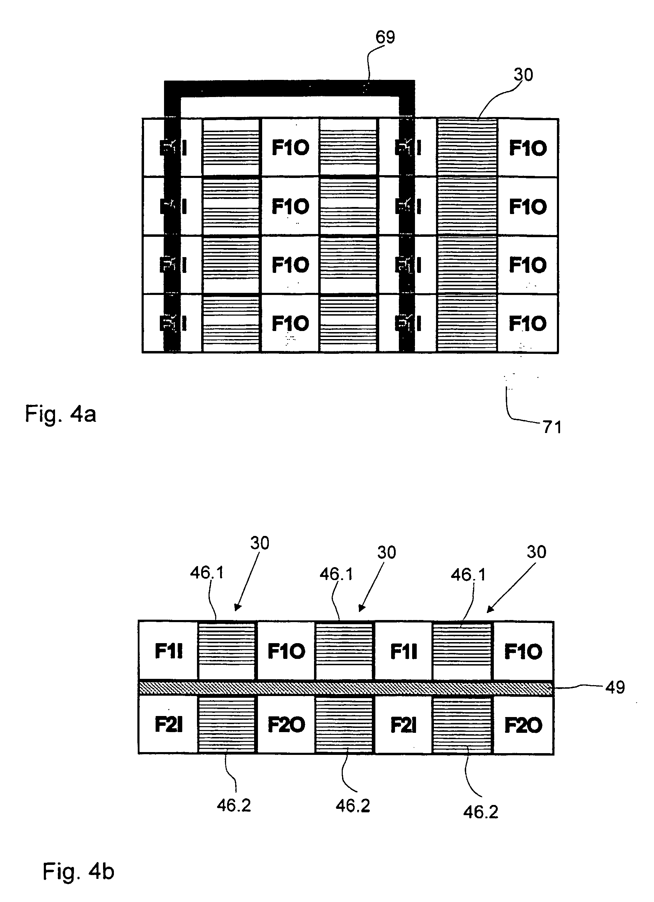

In Fig. 4a ist ein weiteres Beispiel einer matrixförmigen Anordnung einzelner Mikroreaktoren 30 dargestellt. Es handelt sich hierbei um Mikroreaktoren, die nur von einem Medium durchströmt werden. Folglich weist jeder einzelne Mikroreaktor 30 nur einen Einlaufbereich F1I und einen Auslaufbereich F1O auf. Um Einlauf- und Auslaufbereiche benachbarter Mikroreaktoren 30 teilen zu können, sind die in Fig. 4a gezeigten insgesamt 12 Mikroreaktoren in vier parallelen Reihen mit jeweils drei hintereinander liegenden Mikroreaktoren 30 angeordnet. Damit teilen sich benachbarte Mikroreaktoren einer Reihe den Einlaufbereich bzw. den Auslaufbereich. Die Verbindung der einzelnen Einlaufbereiche F1I erfolgt über einen gemeinsamen Kanal 69, während die Verbindung der einzelnen Auslaufbereiche F1O über einen Kanal 71 erfolgt. Auf diese Weise wird ein Mikroreaktor bereitgestellt, der quasi aus insgesamt 12 Teil-Mikroreaktoren aufgebaut ist.

Es ist an dieser Stelle festzuhalten, dass die einzelnen Mikroreaktoren 30 in der in Fig. 4a gezeigten matrixförmigen Anordnung aus einem Cluster einzelner zusammengefasster mikrostrukturierter Schichten entsprechend Fig. 1c aufgebaut sein können und/oder aus einzelnen mikrostrukturierten Schichten, die mittels Abstandshaltern 52, wie sie in Fig. 2 gezeigt sind, verbunden sind.

In Fig. 4b ist ein vertikaler Schnitt einer matrixförmigen Anordnung von Mikroreaktoren 30 dargestellt, aus der ersichtlich ist, dass die einzelnen Mikroreaktoren 30 jeweils ein Cluster mikrostrukturierter Schichten 10 aufweisen. Ferner ist zu erkennen, dass jeder Mikroreaktor 30 insgesamt zwei Cluster 46.1 und 46.2 aufweist, die durch eine Schicht 49 voneinander getrennt sind. Die Mikrokanäle 46.1 werden von dem ersten Fluid F1 und die Mikrokanäle des zweiten Clusters 46.2 von dem zweiten Fluid F2 durchströmt. In dieser Schnittdarstellung ist darüber hinaus deutlich zu erkennen, dass jedes Cluster 46 mit einem gemeinsamen Einlaufbereich und einem gemeinsamen Auslaufbereich verbunden ist.

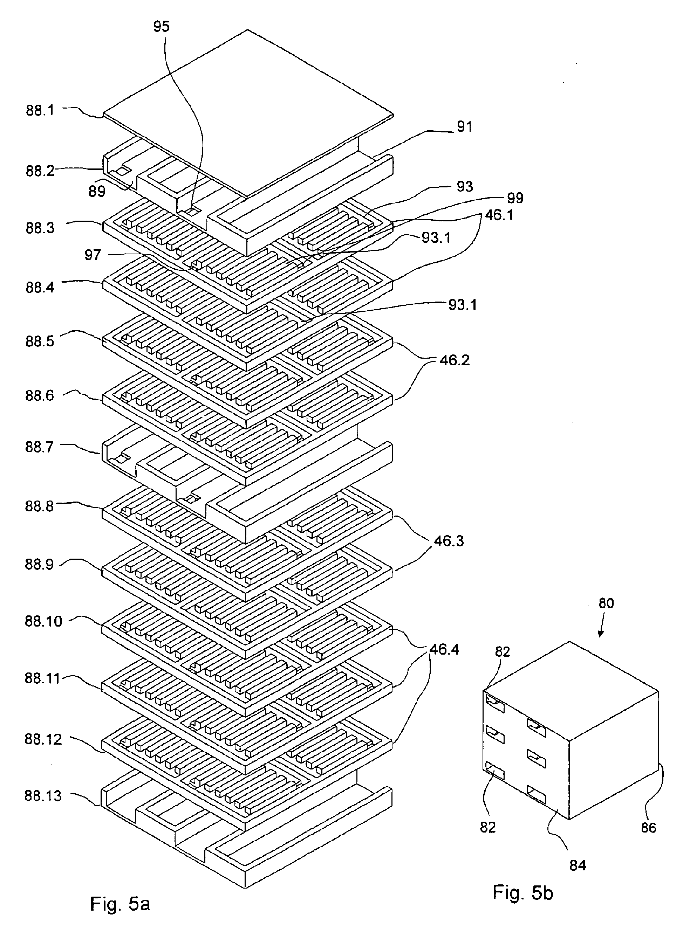

Eine weitere Darstellung eines Mikroreaktors, der matrixförmig angeordnete Teil-Mikroreaktoren einerseits und jeweils zu einem Cluster zusammengefasste mikrostrukturierte Schichten andererseits aufweist, ist in Fig. 5a enthalten. Dieser Mikroreaktor ist in Fig. 5b zusätzlich perspektivisch dargestellt und mit dem Bezugszeichen 80 gekennzeichnet. Das Gehäuse des Mikroreaktors 80 weist mehrere Öffnungen 82 auf, die an der Vorderseite 84 des Gehäuses 80 liegen und der Zuführung eines Mediums dienen. Auf der der Vorderseite 84 gegenüberliegenden Rückseite 86 des Gehäuses sind ebenfalls Öffnungen in entsprechender Anzahl vorgesehen, die versetzt zu den Öffnungen 82 liegen und der Abfuhr des Mediums bzw. der Medien dienen.

Der interne Aufbau dieses Mikroreaktors 80 ist in Fig. 5a in einer isometrischen Darstellung gezeigt. Insgesamt umfasst der Aufbau 13 aufeinander liegende Schichten, die mit den Bezugszeichen 88.1 bis 88.13 durchnummeriert sind.

Zuoberst des Stapels der 13 Schichten liegt eine Deckschicht 88.1, die eine Sammelleitungsschicht 88.2 abdeckt. Diese Sammelleitungsschicht 88.2 weist Einlaufkanäle bzw. -bereiche 89 und Auslaufbereiche 99 auf. Die beiden Einlaufkanäle 89 stehen mit den Öffnungen 82 auf der Vorderseite 84 in Verbindung, während die Auslaufkanäle 91 mit den entsprechenden Öffnungen auf der Rückseite 86 des Gehäuses in Verbindung stehen. Dieser Sammelleitungsschicht 88.2 folgen insgesamt vier mikrostrukturierte Schichten 88.3 bis 88.6, die jeweils vier matrixförmig angeordnete Mikroreaktorbereiche 93 mit entsprechenden Mikrokanälen aufweisen. Diesem Stapel von vier mikrostrukturierten Schichten 88.3 bis 88.6 folgt wiederum eine Sammelleitungsschicht 88.7 und vier weitere mikrostrukturierte Schichten 88.8 bis 88.12, die identisch zu den mikrostrukturierten Schichten 88.3 bis 88.6 ausgebildet sind. Die unterste Schicht des Stapels bildet eine Sammelleitungsschicht 88.13.

In dem in Fig. 5a gezeigten Beispiel sind die beiden mikrostrukturierten Schichten 88.3, 88.4, sowie die beiden Schichten 88.5, 88.6, die beiden Schichten 88.8 und 88.9 und die drei mikrostrukturierten Schichten 88.10 bis 88.12 zu jeweils einem Cluster 46.1, 46.2, 46.3 und 46.4 zusammengefasst.

Betrachtet man nun beispielsweise einen Mikroreaktorbereich 93.1 des Clusters 46.1, so verläuft der Medienstrom wie folgt:
Das Medium wird über eine Öffnung 82 in den Einlaufkanal 89 geführt, wobei dieser Einlaufkanal 89 sich horizontal erstreckt. In diesem horizontalen Einlaufkanal 89 ist eine Öffnung 95 vorgesehen, die einen Zugang in den Mikroreaktorbereich 93.1 erzielt. Über diese Öffnung 95 kann das Medium in diesen Mikroreaktorbereich 93.1 strömen, um dann von dort durch die Mikrokanäle 40 und schließlich über eine entsprechende - nicht dargestellte - Öffnung in den Auslaufkanal 91 zu strömen. Von dort gelangt dann das Medium über die Öffnungen an der Rückseite des Gehäuses nach außen. Um das Medium auch in den Reaktorbereich 93.1 der darunter liegenden mikrostrukturierten Schicht 88.4 zu führen, weist der Mikroreaktorbereich 93.1 eine Öffnung 97 auf, die eine Verbindung nach unten schafft. Durch diese Öffnung 97 kann das Medium aus dem Einlaufkanal 89 und die Öffnung 95 in den unteren Mikroreaktorbereich 93.1 gelangen. Diagonal gegenüber der Öffnung 97 ist im Reaktorbereich 93.1 der mikrostrukturierten Schicht 88.3 eine weitere Öffnung 99 vorgesehen, die eine Verbindung zu dem unteren Mikroreaktorbereich 93.1 der mikrostrukturierten Schicht 88.4 schafft.

Eine solche Anordnung von Öffnungen zur Führung eines Mediums ist auch in den anderen Mikroreaktorbereichen 93 vorgesehen. Darüber hinaus sind auch die mikrostrukturierten Schichten 88 der Cluster 46.2 bis 46.4 in entsprechender Weise ausgebildet, wobei die Mikroreaktorbereiche 93 des Clusters 46.2 und die Mikroreaktorbereiche des Clusters 46.3 über die Sammelleitungsschicht 88.7 versorgt werden. Die Versorgung der Mikroreaktorbereiche des vierten Clusters 46.4 erfolgt dann über die Sammelleitungsschicht 88.13.

Aus dieser Darstellung wird ersichtlich, dass ein Mikroreaktor geschaffen wird, der aus einer Vielzahl von kleineren Mikroreaktorbereichen besteht, die matrixförmig angeordnet sind, so dass die Kanallänge der Mikrokanäle der einzelnen Mikroreaktorbereiche sehr kurz ausfallen kann. Darüber hinaus lassen sich durch die Zusammenfassung mehrerer Schichten, die über gemeinsame Einlauf- und Auslaufbereiche versorgt werden, Druckverluste reduzieren. Insgesamt ist ein sehr kompaktes integriertes Bauteil damit erreichbar.

Es versteht sich, dass die gewählte Anzahl an Schichten und die gewählte Anzahl von Mikroreaktorbereichen pro Cluster an den jeweiligen Anwendungsfall angepasst werden kann und damit nicht auf die gezeigte Anzahl beschränkt ist. Darüber hinaus ist es denkbar, die zu einem Cluster zusammengefassten Schichten in nebeneinander liegenden Reaktorbereichen 93 unterschiedlich zu gestalten, so dass bspw. drei Reaktorbereiche 93.1 zu einem Cluster und benachbart dazu nur zwei Reaktorbereiche 93 zu einem weiteren Cluster zusammengefasst werden.

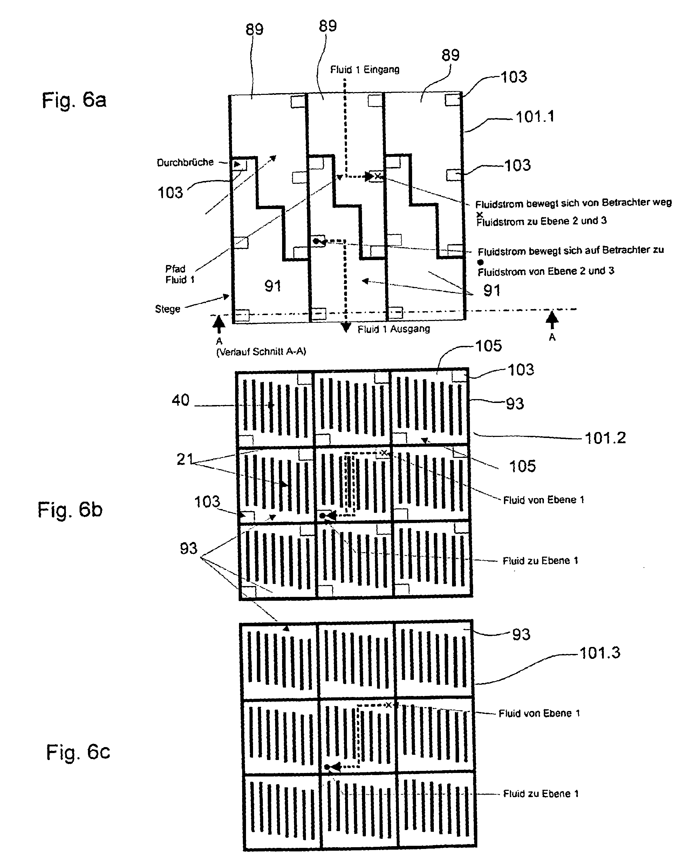

In den Fig. 6a bis i ist ein weiteres Beispiel eines Mikroreaktors dargestellt, der insgesamt neun Schichten umfasst, wobei die mikrostrukturierten Schichten jeweils neuen Mikroreaktorbereiche aufweisen. In den Fig. 6a bis i sind diese neun Ebenen jeweils in Draufsicht dargestellt. Die in Fig. 6a gezeigte erste Ebene ist eine Sammelleitungsschicht 101.1, die mehrere Einlauf- und Auslaufkanäle 89, 91 aufweist. Die Ein- und Auslaufkanäle 89, 91 weisen jeweils drei Durchbrüche 103 auf, die eine Verbindung zu den darunter liegenden Reaktorbereichen 93 schaffen, so dass das in den Einlaufkanal 89 strömendende Medium durch einen solchen Durchbruch 103 in einen darunter liegenden Reaktorbereich 93 strömen kann.

Da die in Fig. 6b gezeigte mikrostrukturierte Schicht 101.2 mit der in Fig. 6c gezeigten mikrostrukturierten Schicht 101.3 zu einem Cluster 46.1 zusammengefasst ist, weisen die jeweiligen Mikroreaktorbereiche 93 der mikrostrukturierten Schicht 101.2 ebenfalls entsprechende Durchbrüche 103 auf, so dass das Medium auch in die darunter liegende mikrostrukturierte Schicht 101.3 und dort in die entsprechenden Mikroreaktorbereiche 93 strömen kann. Die mikrostrukturierte Schicht 101.3 weist jedoch keine weiteren Durchbrüche auf, da sie die unterste Schicht des Clusters bildet.

In Fig. 6b ist deutlich zu erkennen, dass die Mikrokanäle 40 eines jeden Mikroreaktorbereiches 93 so angeordnet sind, dass sich ein konischer Kanal bzw. Bereich von bzw. zu dem Durchbruch 103 ergibt, wobei die Breite dieses Kanals im Bereich des Durchbruchs 103 am größten ist. Ferner ergibt sich aus den beiden Fig. 6b und 6c, dass die Anordnung der Mikrostrukturen, d.h. der Mikrokanäle in den einzelnen Reaktorbereichen 93 in den beiden Schichten 101.2 und 101.3 gleich gewählt ist.

Darüber hinaus ist an dieser Stelle noch anzumerken, dass beispielsweise zwischen die Schichten 101.1 und 101.2 eine Zusatzschicht eingebracht werden könnte, beispielsweise aus einem anderen Material oder zur Ausbildung eines Hohlraums, um eine thermische Trennung zu erreichen.

Die weiteren mikrostrukturierten Schichten 101.4 und 101.6 bis 101.8 sind ähnlich ausgebildet, so dass auf eine detaillierte Beschreibung an dieser Stelle verzichtet werden kann. Festzuhalten ist lediglich, dass die Anordnung der Mikrokanäle in einzelnen Mikroreaktorbereichen 93 unterschiedlich ausfällt, so dass die Strömungsrichtung in unterschiedlichen Reaktorbereichen 93 auch unterschiedlich ausfällt. Damit ist beispielsweise eine Kreuzstrom-Anordnung erreichbar.

Die Sammelleitungsschicht 101.5 ist entsprechend zu der Sammelleitungsschicht 101.1 ausgebildet, allerdings mit dem Unterschied, dass die Strömungsrichtung bzw. die Längserstreckung der Einlauf- und Auslaufbereiche um 90° verdreht ist. Ansonsten ist die Funktionsweise identisch. Über diese Sammelleitungsschicht 101.5 werden die mikrostrukturierten Schichten 101.4, 101.6 und 101.7 mit einem zweiten Medium versorgt.

Schließlich weist die Anordnung noch eine mikrostrukturierte Schicht 101.8 und eine abschließende Sammelleitungsschicht 101.9 auf. Diese Sammelleitungsschicht 101.9 ist identisch zu der Sammelleitungsschicht 101.1 ausgebildet mit der Ausnahme, dass keine Durchbrüche mehr vorgesehen sein müssen. Die Versorgung der darüber liegenden mikrostrukturierten Schicht 101.8 erfordert lediglich entsprechende Durchbrüche in dieser mikrostrukturierten Schicht 101.8.

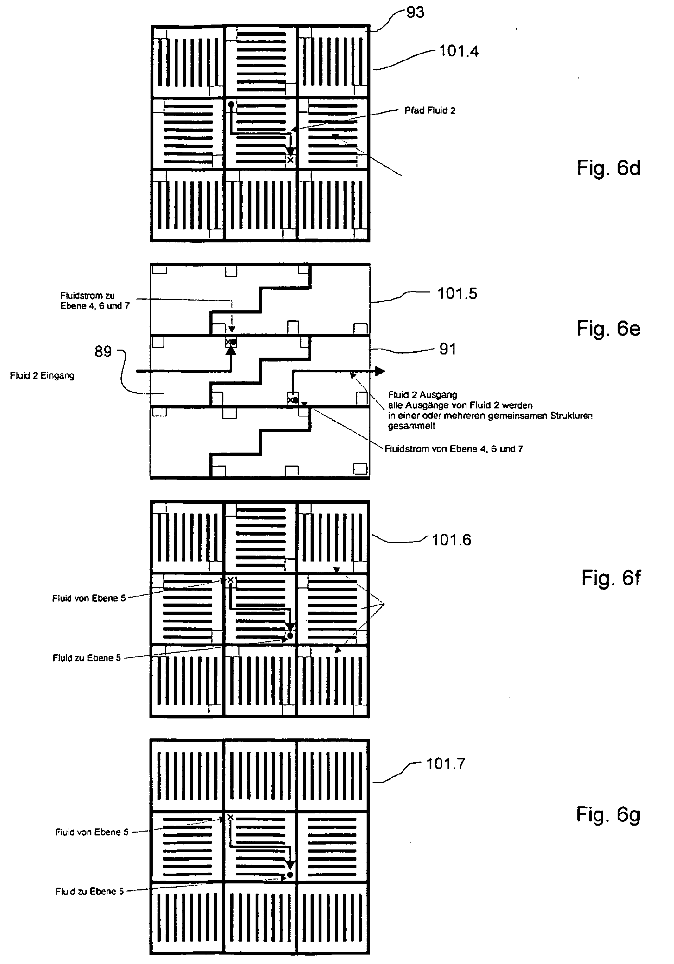

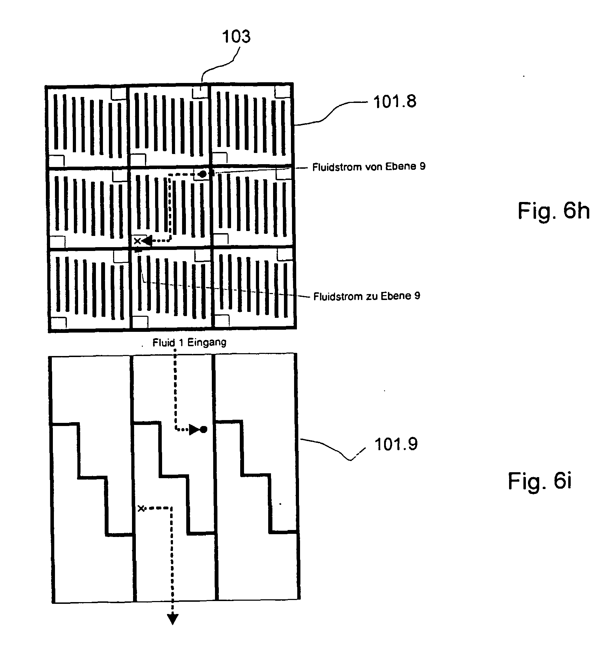

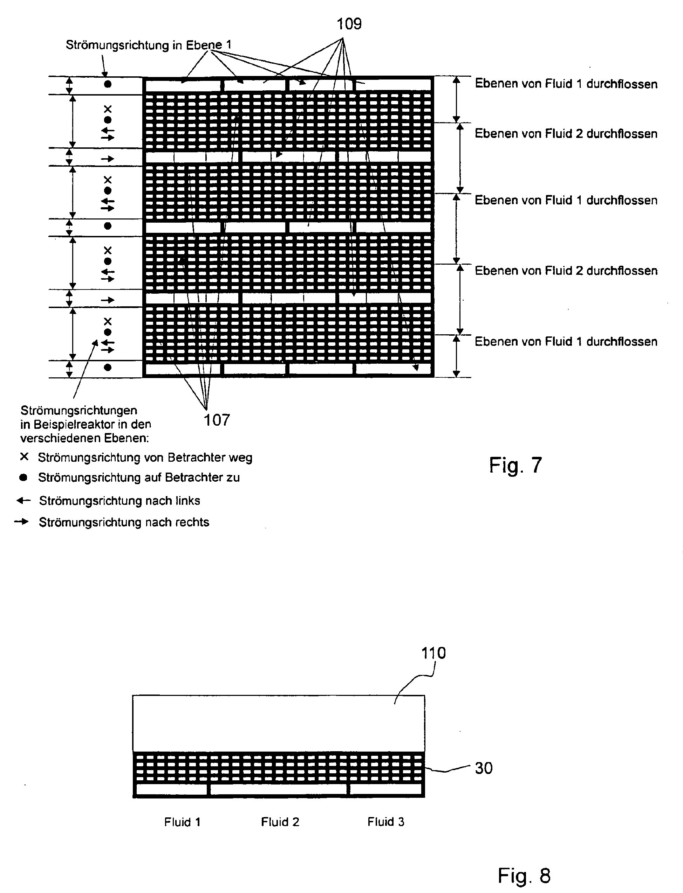

In Fig. 7 ist eine Schnittdarstellung durch den in Fig. 6 gezeigten Mikroreaktor dargestellt, wobei allerdings mehr als neun Ebenen vorgesehen sind. Der gesamte Aufbau umfasst mikrostrukturierte Schichten 107, die über Sammelleitungsschichten 109 - wie in dem vorgenannten Beispiel - mit den jeweiligen Medien versorgt werden.

In Fig. 8 ist ein Verwendungsbeispiel eines Mikroreaktors 30 dargestellt. Dieser Mikroreaktor 30 besteht aus matrixförmig angeordneten Reaktorbereichen einzelner zu Clustern zusammengefassten mikrostrukturierten Schichten. In Fig. 8 ist angedeutet, dass der Mikroreaktor 30 von drei Fluiden durchströmt wird. Selbstverständlich wäre es auch denkbar, dass der Mikroreaktor nur von einem oder von zweien Fluiden durchströmt wird. Das zu temperierende Bauteil 110 ist auf dem Mikroreaktor 30 in einem gut wärmeleitenden Kontakt angeordnet, wobei es sich bei dem Bauteil 110 beispielsweise um eine CPU oder ein Bauteil mit mehreren Temperaturzonen handelt.

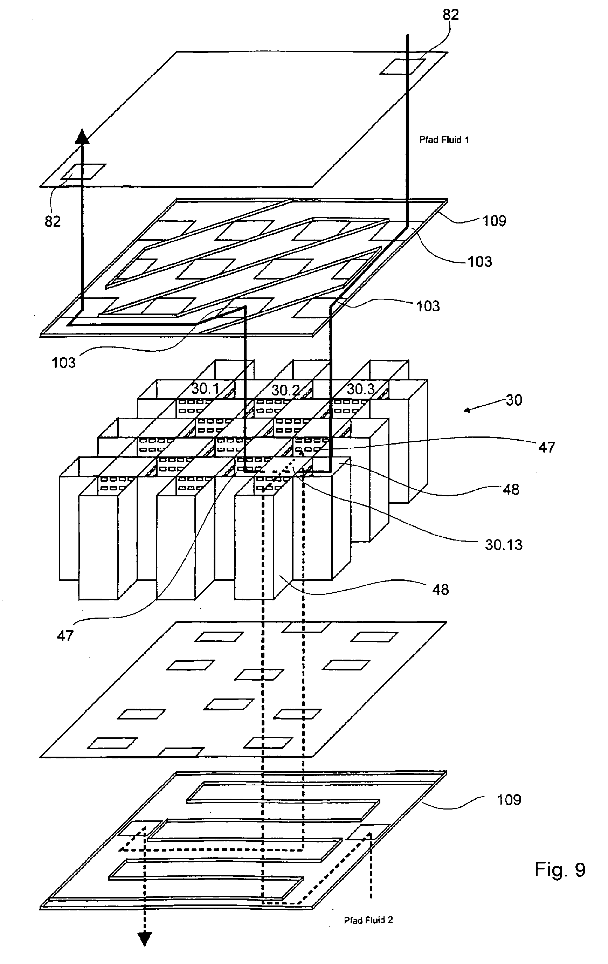

In Fig. 9 ist eine weitere Darstellung eines Mikroreaktors gezeigt, wobei der Aufbau des Mikroreaktors 30 der in Fig. 3b gezeigten und erläuterten Anordnung entspricht.

Der hier gezeigte Mikroreaktor 30 umfasst insgesamt 13 kleinere Mikroreaktoren 30.1 bis 30.13 bzw. Mikroreaktorbereiche, die aus übereinanderliegenden mikrostrukturierten Schichten aufgebaut sind. Deutlich zu erkennen ist in dieser Darstellung, dass jedem Mikroreaktor 30.1 bis 30.13 Einlauf- und Auslaufbereiche 48, 47 zugeordnet sind, die er jedoch mit benachbarten Mikroreaktoren teilt. Mithilfe einer durchgehenden Linie ist der Strömungsweg eines ersten Fluids beispielhaft durch eine Schicht eines Mikroreaktors 13.13 gezeigt, wobei das Medium durch eine Öffnung 82 in eine Sammelleitungsschicht 109 und von dort über Durchbrüche 103 in die jeweiligen Einlaufbereiche 48 strömt. Von dort gelangt das Medium durch die Mikrokanäle in den Auslaufbereich 47 und von dort über einen entsprechenden Durchbruch 103 in der Sammelleitungsschicht 109 und eine Öffnung 82 in der obersten Schicht nach außen. In analoger Weise durchströmt das zweite Fluid entlang dem gestrichelt dargestellten Strömungsweg die untere Sammelleitungsschicht 109 den Einlaufbereich 48, den Mikroreaktor 30.13 und den Auslaufbereich 47.

In den bisherigen Ausführungsbeispielen weisen die Mikroreaktoren bzw. die einzelnen Mikroreaktorbereiche eine quadratische bzw. rechteckförmige Grundfläche auf, wobei sich die Mikrokanäle selbst geradlinig erstrecken.

Es versteht sich jedoch, dass die vorliegende Erfindung nicht auf diese Form beschränkt ist. Andere Formen der Mikroreaktoren bzw. der Mikroreaktorbereiche sind denkbar.

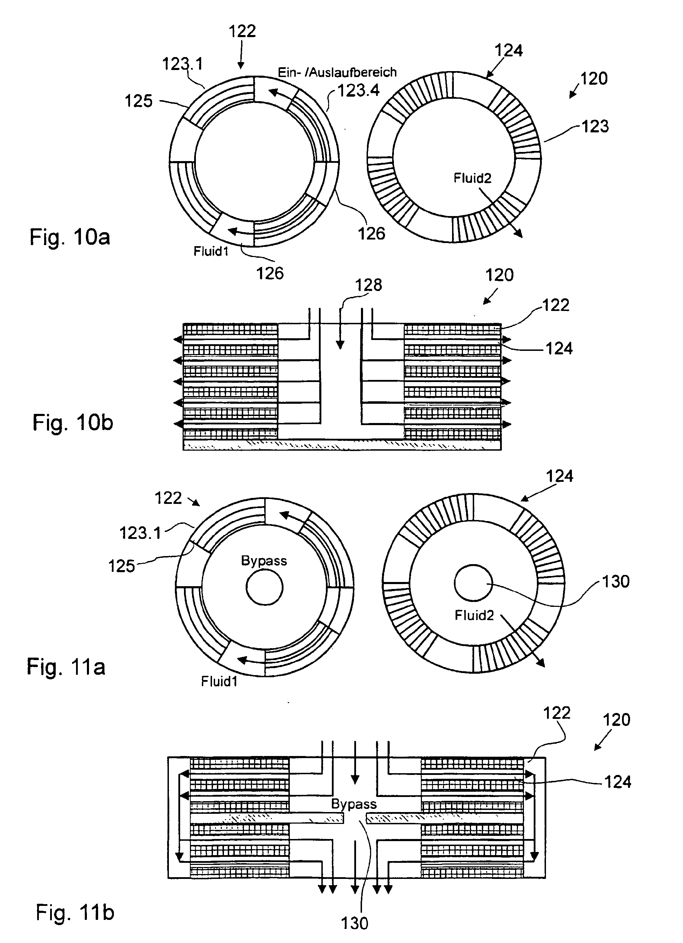

So ist beispielsweise in den Fig. 10 und 11 ein Beispiel für eine andere Art der Ausgestaltung von Mikroreaktorbereichen und eine andere Art der bisher beschriebenen Anordnung einzelner Mikroreaktorbereiche dargestellt.

In Fig. 10 ist ein Mikroreaktor 120 gezeigt, wobei Fig. 10a eine Draufsicht der in dem Mikroreaktor 120 verwendeten zwei unterschiedlichen Cluster 122 und 124 zeigt, während Fig. 10b eine Schnittansicht des Mikroreaktors 120 zeigt.

Der Cluster 122 weist mehrere ringförmige Reaktorbereiche 123.1 bis 123.4 auf, wobei diese Reaktorbereiche aus mehreren mikrostrukturierten Schichten zur Bildung eines Clusters aufgebaut sind. Die einzelnen Mikrokanäle 125 der mikrostrukturierten Schichten der Reaktorbereiche 123 verlaufen - wie dargestellt - kreisförmig, und damit nicht wie bei den vorherigen Beispielen geradlinig. Zwischen den einzelnen Reaktorbereichen 123 sind Einlauf- und Auslaufbereiche vorgesehen, so dass das Medium kreisförmig strömen kann.

Die Clusteranordnung 124 unterscheidet sich dahingehend, dass die Reaktorbereiche 123 aus einzelnen mikrostrukturierten Schichten aufgebaut sind, deren Mikrokanäle radial verlaufen, so dass ein Medium diese Bereiche 123 radial durchströmen kann.

Aus der Schnittdarstellung der Fig. 10b ist ersichtlich, dass die beiden Clusteranordnungen 122, 124 alternierend zur Ausbildung des Mikroreaktors 120 gestapelt sind.

Mithilfe dieses Mikroreaktors 120 ist es beispielsweise möglich, ein in der Clusteranordnung 122 strömendes Medium (Flüssigkeit) durch Luft zu kühlen, die axial in den Mikroreaktor 120 einströmt, wie dies durch einen Pfeil 128 angedeutet ist, und dann radial durch die Reaktorbereiche 123 der Clusteranordnungen 124 ausströmt.

Eine Modifikation dieses Mikroreaktors 120 ist in Fig. 11a und 11b dargestellt.

Einer der Unterschiede besteht darin, dass das durch die Reaktorbereiche der Clusteranordnung 124 fließende Fluid auch über einen Bypass 130 unter Umgehung der Reaktorbereiche 123 aus dem Mikroreaktor 120 ausströmen kann. Der Bypass ist zentrisch innerhalb des kreisförmigen Mikroreaktors 120 angeordnet.

Ein solcher Bypass ist beispielsweise dann notwendig, wenn unter extremen Temperaturbedingungen der Durchfluss des Mediums sichergestellt werden muss. Dies gilt gerade bei Anwendungen im Fahrzeugbereich, wo Öl gekühlt werden muss, das bei sehr niedrigen Temperaturen zähflüssig ist und damit möglicherweise nicht durch die Mikrokanäle strömen kann.

Die in Fig. 10 und 11 gezeigten Beispiele können auch dann eingesetzt werden, wenn Wärme z.B. zwischen Fluiden mit verschiedenen Viskositäten übertragen werden muss oder wenn unterschiedliche Druckverluste zulässig sind. Hierbei kann man dann die Kanallängen der Mikrokanäle entsprechend unterschiedlich lang gestalten. Es lässt sich z.B. durch die kreisförmige Anordnung die Zu- und Abfuhr für jeweils ein Fluid sehr vorteilhaft gestalten.

Darüber hinaus weist der in Fig. 10 gezeigte Aufbau des Mikroreaktors 120 eine besondere Eignung für Systeme mit korrosiven Medien oder hohen Anforderungen an die Materialwahl des Wärmeüberträgers auf. In diesen Fällen kommt Edelstahl mit einer sehr geringen Wärmeleitfähigkeit und damit geringer Eignung zum Einsatz von Finnen zur Anwendung. Beispielsweise müssen in bestimmten Brennstoffzellensystemen empfindliche Wasser-Methanolgemische temperiert werden.

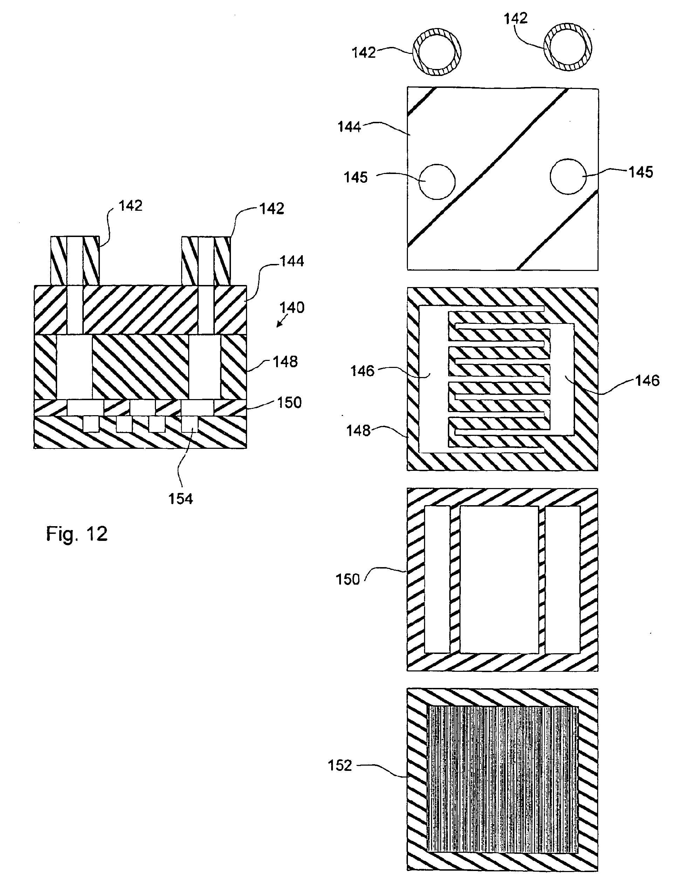

Ein Beispiel eines Mikroreaktors ist in Fig. 12 dargestellt. Bei dem Mikroreaktor handelt es sich um einen Kühler 140, der von einem flüssigen Medium, beispielsweise Wasser, durchströmt wird. Der Kühler dient beispielsweise zur Kühlung von Mikroprozessoren.

Der Kühler 140 ist aus verschiedenen Einzelelementen zusammengesetzt, die in Fig. 12 jeweils in Draufsicht dargestellt sind. Der Kühler 140 umfasst Anschlüsse 142, die üblicherweise auf einer Deckplatte 144 befestigt sind. Die Anschlüsse 142 dienen dazu, Schläuche bzw. Leitungen für das Fluid aufzunehmen. In der Deckplatte 144 sind entsprechende Öffnungen 145 vorgesehen, die in Bereiche 146 einer Zu- und Abfuhrschicht 148 münden. Diese Zu- und Abfuhrschicht 148 stellt die Sammelleitungsschicht, wie sie zuvor in den Ausführungsbeispielen beschrieben wurde, dar. An diese Zu- und Abfuhrschicht 148 schließt sich ein Abstandshalter 150 an, der auf einer mikrostrukturierten Schicht 152 liegt. Die mikrostrukturierte Schicht 152 umfasst insgesamt eine Ebene von Mikrokanälen 154. An der Unterseite dieser mikrostrukturierten Schicht 152 ist dann der zu kühlende Mikroprozessor angebracht.

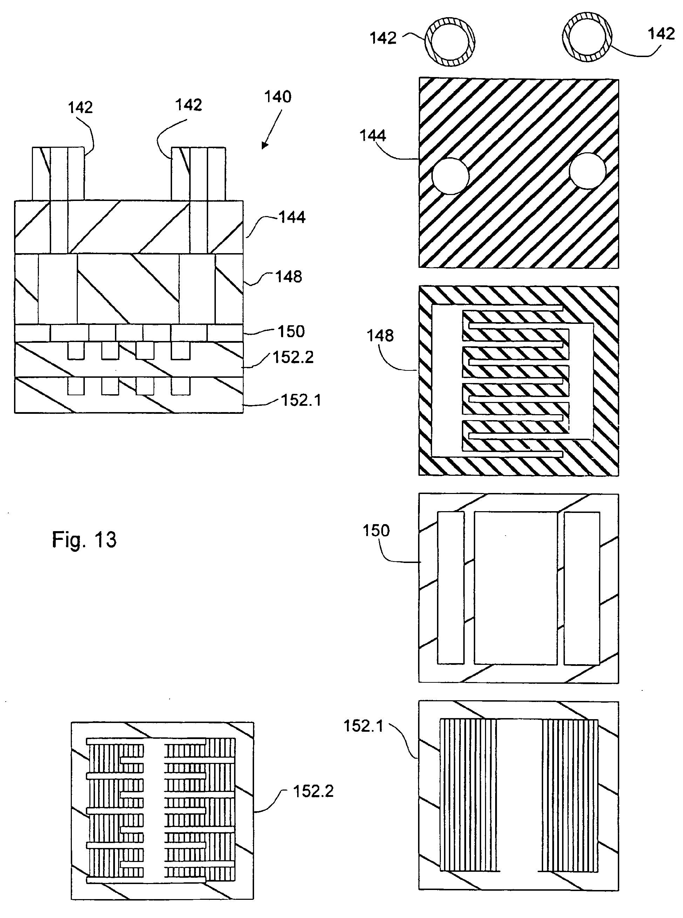

In Fig. 13 ist eine weitere Variante des zuvor beschriebenen Kühlers 140 dargestellt, wobei zur Vereinfachung gleiche Teile mit gleichem Bezugszeichen gekennzeichnet sind. Im Unterschied zu dem vorgenannten Beispiel umfasst die mikrostrukturierte Schicht 152 zumindest zwei einzelne mikrostrukturierte Schichten 152.1 und 152.2, die übereinander liegen. Die beiden mikrostrukturierten Schichten 152.1 und 152.2 weisen jeweils Aussparungen auf, um zu ermöglichen, dass das Fluid von der oberen mikrostrukturierten Schicht 152.2 auch in die darunter liegende mikrostrukturierte Schicht 152.1 ein- und ausfließen kann.

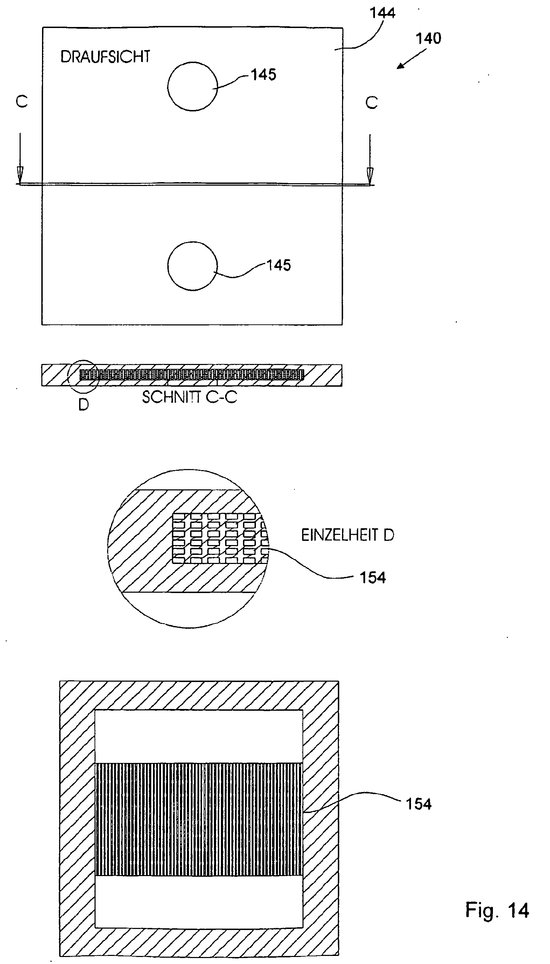

In Fig. 14 ist eine weitere Ausgestaltung eines Kühlers 140 zur Kühlung von elektronischen Bauelementen, insbesondere Mikroprozessoren, dargestellt. Der Kühler 140 weist eine Deckplatte 144 auf, die Öffnungen 145 umfasst. Innerhalb des Kühlers 140 ist eine Anzahl von mikrostrukturierten Schichten angeordnet, die eine Vielzahl von Mikrokanälen 154 in mehreren Ebenen bereitstellen. Die Mikrokanäle 154 sind dabei mit Ein- und Auslaufbereichen verbunden, die ihrerseits mit den Öffnungen 145 in Verbindung stehen, so dass ein in eine Öffnung 145 einströmendes Medium in den Einlaufbereich, von dort in die Vielzahl von Mikrokanälen 154, dann in den Auslaufbereich, und über die andere Öffnung 145 wieder ausströmen kann. Im gezeigten Beispiel sind die Mikrokanäle 154 nicht segmentiert, d.h. dass ein einzelner Mikroreaktor-Bereich im Kühler vorgesehen ist, wie dies auch aus der unteren Draufsicht in Fig. 14 zu erkennen ist.

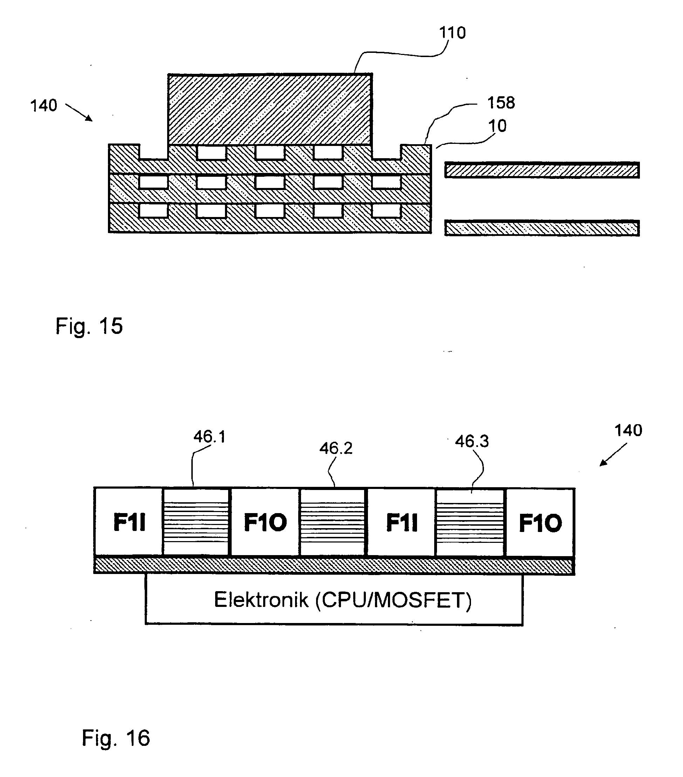

Der Aufbau und die Anordnung der einzelnen Mikrokanäle 154 dieses Kühlers 140 kann nach den zuvor erläuterten Prinzipien erfolgen. So ist es beispielsweise denkbar, wie dies in Fig. 16 schematisch gezeigt ist, mehrere Cluster aus einzelnen mikrostrukturierten Schichten entsprechend dem in Fig. 4a gezeigten Prinzip anzuordnen.

In Fig. 15 ist ebenfalls ein Kühler 140 schematisch dargestellt, der ein Bauteil 110 kühlen soll. Hierbei ist die mit dem Bauteil 110 in Kontakt kommende Oberfläche 158 der mikrostrukturierten Schicht 10 ebenfalls mit einer Mikrostruktur versehen, wobei sich diese Mikrostruktur jedoch von den bisher beschriebenen Strukturen unterscheidet. Dies hat den Vorteil, dass die Hilfsstoffe abfließen oder verdrängt werden können, die zur Kontaktierung des Bauteils 110 mit der Oberfläche 158 verwendet werden. Bei diesen Hilfsstoffen handelt es sich beispielsweise um Wärmeleitpasten, Lote etc.

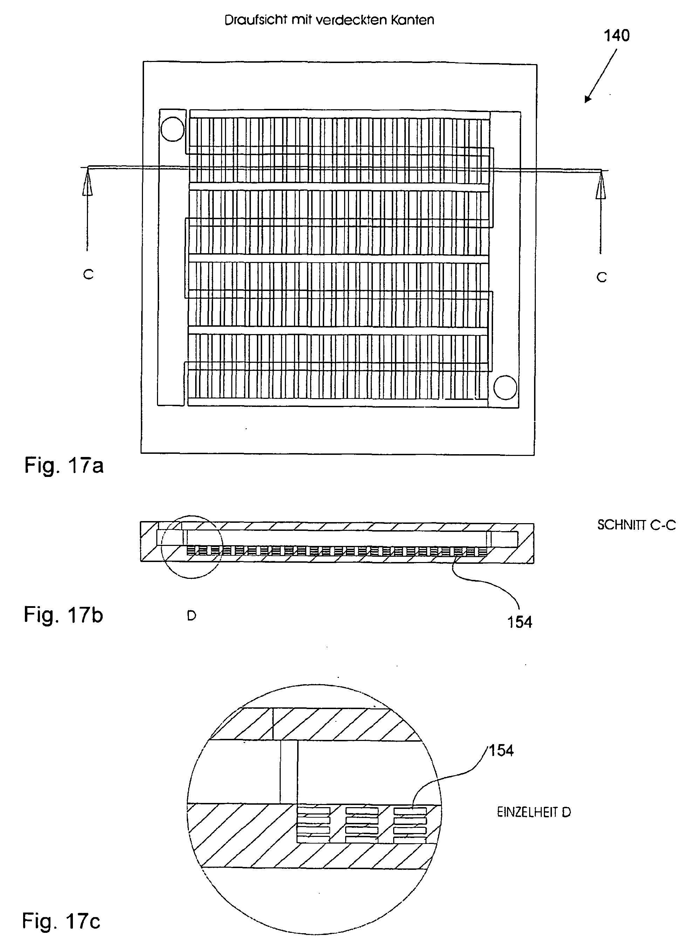

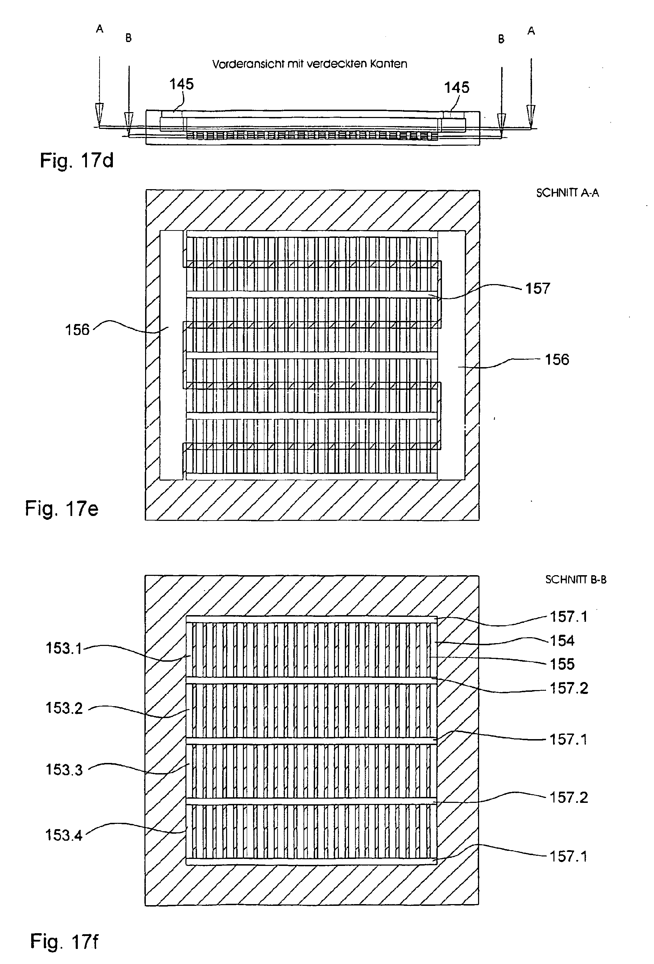

Ein weiteres Beispiel eine Kühlers 140 ist in den Figuren 17a-f dargestellt. Dieser Kühler entspricht im wesentlichen dem in Fig. 14 gezeigten Kühler, allerdings mit der Ausnahme, dass mehrere Mikroreaktorbereiche 153 vorgesehen sind. Im Beispiel sind insgesamt vier Mikroreaktorbereiche 153.1-153.4 vorgesehen, die hintereinander geschaltet sind. Die einzelnen Mikroreaktorbereiche 153 werden durch quer zu den Mikrokanälen 154 verlaufende Sammelleitungen 157.1-157.5 begrenzt. In diese Sammelleitungen münden die Mikrokanäle 154 der einzelnen Mikroreaktorbereiche ein. Im vorliegenden Beispiel sind insgesamt fünf Sammelleitungen 157 vorgesehen, wobei bspw. die Sammelleitungen 157.1, 157.3 und 157.5 als Einlaufbereich und die anderen beiden Sammelleitungen 157.2 und 157.4 als Auslaufbereich dienen. Eine entsprechende Darstellung findet sich in Fig. 17f.

Aus der Fig. 17e ist ersichtlich, dass die Sammelleitungen in größere Sammelleitungen 156 münden, die allerdings in einer anderen Ebene liegen.

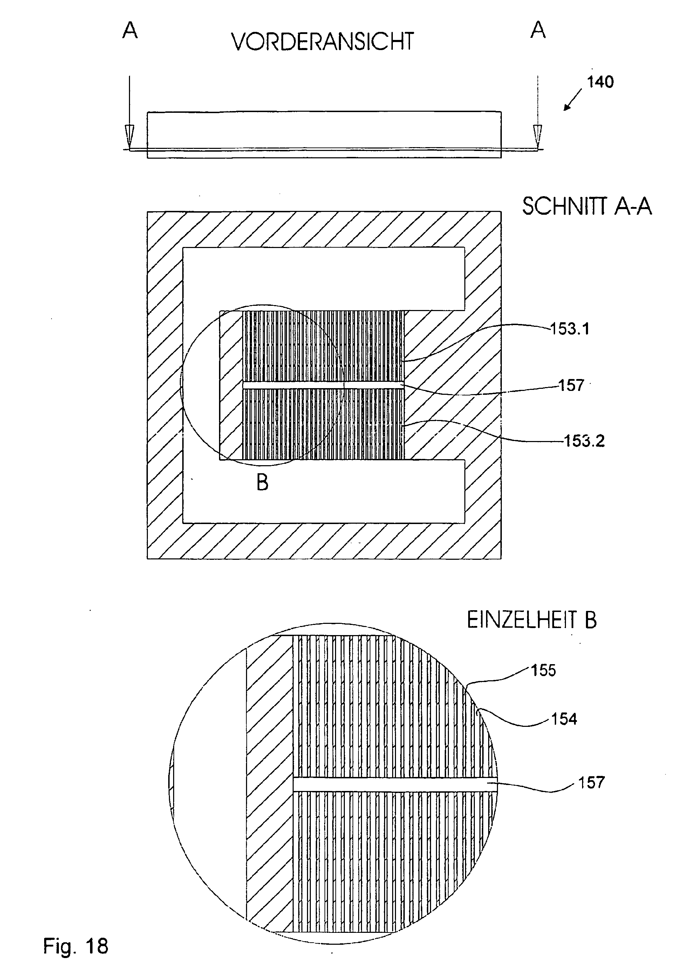

Ein weiteres Beispiel eines Kühlers 140 ist in Fig. 18 dargestellt. Dieser Kühler unterscheidet sich gegenüber dem vorgenannten Kühler dadurch, dass lediglich zwei Mikroreaktorbereiche 153.1 und 153.2 vorgesehen sind, die durch eine Sammelleitung 157 getrennt sind.

Zusammenfassend zeigt sich, dass es mit den vorgenannten Lösungen gelingt, die Leistungsfähigkeit von Mikroreaktoren zu höheren Leistungen zu skalieren, ohne die bisher aufgetretenen hohen Druckverluste hinnehmen zu müssen. Hierbei sei an dieser Stelle nochmals angemerkt, dass die vorgenannten Lösungen alleine oder in Kombination miteinander eingesetzt werden können.

Die zuvor beschriebenen Lösungen zeigen also Wege auf, wie man auf Mikrostrukturtechnologie basierende Bauteile fast beliebig in der Größe skalieren kann und gleichzeitig den Druckverlust gezielt auf ein Minimum einstellen kann. Betrachtet man heute den Stand der Technik, so ist bisweilen kein Bauteilkonzept und ein dazupassendes Herstellungsverfahren bekannt, mit dem sich kostengünstig Mikrostrukturen herstellen lassen, so dass die Technologie in der Automobil oder Computerbranche keine Anwendung findet. Besonders wichtig ist daher, dass die hier beschriebenen Lösungen einfach und kostengünstig herstellbare Strukturen enthalten und gleichzeitig extrem leistungsfähige Bauteile realisieren lassen. Die Massenproduktion von mikrostrukturierten Bauteilen wird daher erstmals möglich

## Patentansprüche

1. Mikroreaktor mit
mehreren zu einem Schichtenstapel (42) zusammengefassten einzelnen Schichten (10, 32), welcher Schichtenstapel eine Deckschicht (32) und eine Kanalschicht (10) aufweist, wobei die Kanalschicht (10) zumindest zwei einzelne Schichten (10.1-10.3) umfasst, die jeweils auf zumindest einer Seite (14) Mikrostrukturen (18) aufweisent, die zusammen mit der zugewandten Seite der benachbarten Deckschicht (32) bzw. der einzelnen Schicht (10.2-10.3) Mikrokanäle (40) bilden, und
zumindest einem Einlaufkanal (48) und zumindest einem Auslaufkanal (47), die mit den Mikrokanälen (40) in Verbindung stehen, so dass ein über den Einlaufkanal (48) eingeleitetes Medium die Mikrokanäle (40) durchströmen und über den Auslaufkanal (47) ausströmen kann und einen Mikroreaktorbereich bilden (93), **dadurch gekennzeichnet, dass**
mehrere Mikroreaktorbereiche (93) innerhalb einer Kanalschicht vorgesehen und matrixförmig angeordnet sind, wobei Einlauf- und Auslaufkanäle (48, 47;) benachbarter Mikroreaktorbereiche (93) miteinander verbunden sind.

2. Mikroreaktor nach Anspruch 1, **dadurch gekennzeichnet, dass** die einzelnen Schichten (10) in einem thermisch gut gekoppelten Verbund stehen, die einzelnen Schichten (10.1-10.3) der Kanalschicht (10) gleich ausgebildet sind; die einzelnen Schichten der Kanalschicht (10) ausgerichtet zueinander angeordnet sind, so dass Stege der Mikrokanäle der einzelnen Schichten übereinander liegen; und die Mikrokanäle (40) mit dem Einlaufkanal (48) und dem Auslaufkanal (47) verbunden sind.

3. Mikroreaktor nach Anspruch 1, **dadurch gekennzeichnet, dass** die einzelnen Schichten der Kanalschicht gleich ausgebildet sind.

4. Mikroreaktor nach Anspruch 3, **dadurch gekennzeichnet, dass** die einzelnen Schichten der Kanalschicht ausgerichtet zueinander angeordnet sind, so dass Stege der Mikrokanäle der einzelnen Schichten übereinander liegen.

5. Mikroreaktor nach einem der vorhergehenden Ansprüche, **dadurch gekennzeichnet, dass** die Kanalschicht eine Vielzahl der einzelnen Schichten aufweist.

6. Mikroreaktor nach einem der vorhergehenden Ansprüche, **dadurch gekennzeichnet, dass** die Mikrokanäle der einzelnen Schichten parallel zueinander verlaufen.

7. Mikroreaktor nach einem der vorhergehenden Ansprüche, **dadurch gekennzeichnet, dass** die Mikrostrukturen durch Ätzen hergestellt sind, wobei sich dadurch ein etwa halb-elliptischer Querschnitt ergibt.

8. Mikroreaktor nach einem der Ansprüche 1 bis 6, **dadurch gekennzeichnet, dass** die Mikrostrukturen durch Prägen hergestellt sind.

9. Mikroreaktor nach einem der vorhergehenden Ansprüche, **dadurch gekennzeichnet, dass** zumindest zwei Kanalschichten aufeinander angeordnet sind und einen Schichtenblock bilden, wobei jede Kanalschicht einen eigenen Einlauf- und Auslaufkanal aufweist, so dass die Kanalschichten des Schichtenblocks mit unterschiedlichen Medien durchströmbar sind.

10. Mikroreaktor nach Anspruch 9, **dadurch gekennzeichnet, dass** die Mikrokanäle unterschiedlicher Kanalschichten eines Schichtenblocks in unterschiedliche Richtungen verlaufen, vorzugsweise in einem Winkel von 90° zueinander versetzt sind (Kreuzstromanordnung).

11. Mikroreaktor nach einem der vorhergehenden Ansprüche, **dadurch gekennzeichnet, dass** zumindest ein Abstands- und Verbindungsmittel (Verbindungsmittel) zwischen zwei einzelnen Schichten der Kanalschicht vorgesehen ist, um die beiden Schichten miteinander zu verbinden und den Querschnitt sowie die aktive Oberfläche der Mikrokanäle zu vergrößern.

12. Mikroreaktor nach Anspruch 11, **dadurch gekennzeichnet, dass** das Verbindungsmittel als Schicht ausgebildet ist, die im Bereich der Mikrostrukturen Aussparungen bzw. Durchbrüche aufweist.

13. Mikroreaktor nach Anspruch 12, **dadurch gekennzeichnet, dass** Verbindungsmittel ein beschichteter Draht ist, der die Mikrostruktur umgibt, so dass das Medium in den Mikrokanälen bleibt.

14. Mikroreaktor nach einem der vorhergehenden Ansprüche, **dadurch gekennzeichnet, dass** die Mikrokanäle eine Breite im Bereich von 400µm, eine Tiefe von 200µm und eine Länge von 8mm-20mm aufweisen.

15. Mikroreaktor nach einem der vorhergehenden Ansprüche, **dadurch gekennzeichnet, dass** der Abstand benachbarter Mikrokanäle einer Schicht im Bereich von 200 - 300µm liegt, so dass die zwischen zwei Mikrokanälen ausgebildeten Stege eine Breite von 200 - 300µm aufweisen.

16. Mikroreaktor nach Anspruch 5, **dadurch gekennzeichnet, dass** die Kanalschicht zwischen 2 und 20 einzelne mikrostrukturierte Schichten umfasst.

17. Mikroreaktor nach einem der vorhergehenden Ansprüche, **dadurch gekennzeichnet, dass** der Schichtenstapel eine rechteckige Grundfläche aufweist, vorzugsweise eine Grundfläche von 50mm auf SOmm oder weniger aufweist.

18. Mikroreaktor nach einem der vorhergehenden Ansprüche, **dadurch gekennzeichnet, dass** der Einlauf- und der Auslaufkanal senkrecht zu der Kanalschicht und den Mikrokanälen verläuft.

19. Mikroreaktor nach einem der vorhergehenden Ansprüche, **dadurch gekennzeichnet, dass** die einzeln Schichten des Schichtenstapels miteinander verlötet oder verschweißt sind.

20. Mikroreaktor nach einem der vorhergehenden Ansprüche, **dadurch gekennzeichnet, dass** der Mikroreaktor als Kühler für ein elektronisches Bauelement ausgebildet ist, wobei die der Mikrostruktur abgewandte Fläche der Kanalschicht mit dem Bauelement thermisch koppelbar ist.

21. Mikroreaktor nach Anspruch 20, **dadurch gekennzeichnet, dass** die thermisch gekoppelte Fläche eine Mikrostruktur aufweist.

22. Mikroreaktor nach einem der vorhergehenden Ansprüche, **dadurch gekennzeichnet, dass** ein Bypass vorgesehen ist, um das Medium vom Einlaufkanal zum Auslaufkanal unter teilweiser oder vollständiger Umgehung der Mikrokanäle zu führen.

23. Mikroreaktor nach Anspruch 1, **dadurch gekennzeichnet, dass** Hohlräume zwischen einzelnen Schichtenstapel vorgesehen sind, um eine thermische Entkopplung vorzusehen.

24. Mikroreaktor nach einem der vorhergehenden Ansprüche, **dadurch gekennzeichnet, dass** die Schichten aus unterschiedlichen Materialien bestehen.

25. Mikroreaktor nach einem der vorhergehenden Ansprüche, **dadurch gekennzeichnet, dass** zumindest eine Schicht aus einem Metall, vorzugsweise Kupfer, Aluminium oder Edelstahl besteht.

26. Mikroreaktor nach einem der vorhergehenden Ansprüche, **dadurch gekennzeichnet, dass** zumindest eine Schicht aus einem Kunststoff besteht.

27. Mikroreaktor nach einem der vorhergehenden Ansprüche, **dadurch gekennzeichnet, dass** weitere Komponenten integriert sind, vorzugsweise chemische Reaktoren und Mischeinrichtungen.

28. Mikroreaktor nach einem der vorhergehenden Ansprüche, **dadurch gekennzeichnet, dass** zumindest in einem Mikrokanal, vorzugsweise in den Mikrokanälen einer einzelnen Schicht ein Katalysator aufgebracht ist.

29. Mikroreaktor-Anordnung, **dadurch gekennzeichnet, dass** mehrere Mikroreaktoren nach einem der Ansprüche 1 bis 28 miteinander verschaltet sind, um ein integriertes Bauteil bereitzustellen.

## Claims

1. Microreactor comprising
a plurality of individual layers (10, 32) combined to form a layer stack (42), which layer stack has a covering layer (32) and a channel layer (10), wherein the channel layer (10) comprises at least two individual layers (10.1-10.3) which each have on at least one side (14) microstructures (18) which together with the facing side of the adjacent covering layer (32) or the individual layer (10.2-10.3) form microchannels (40), and
at least one inlet channel (48) and at least one outlet channel (47), which are connected to the microchannels (40), such that a medium introduced via the inlet channel (48) can flow through the microchannels (40) and can flow out via the outlet channel (47), and form a microreactor region (93), **characterized in that**
a plurality of microreactor regions (93) are provided within a channel layer and arranged in a matrix-type fashion, wherein inlet and outlet channels (48, 47) of adjacent microreactor regions (93) are connected to one another.

2. Microreactor according to Claim 1, **characterized in that** the individual layers (10) are in a thermally well coupled composite assembly, the individual layers (10.1-10.3) of the channel layer (10) are embodied identically; the individual layers of the channel layer (10) are arranged in a manner aligned with one another, such that webs of the microchannels of the individual layers lie one above another; and the microchannels (40) are connected to the inlet channel (48) and the outlet channel (47).

3. Microreactor according to Claim 1, **characterized in that** the individual layers of the channel layer are embodied identically.

4. Microreactor according to Claim 3, **characterized in that** the individual layers of the channel layer are arranged in a manner aligned with one another, such that webs of the microchannels of the individual layers lie one above another.

5. Microreactor according to any of the preceding claims, **characterized in that** the channel layer has a multiplicity of the individual layers.

6. Microreactor according to any of the preceding claims, **characterized in that** the microchannels of the individual layers run parallel to one another.

7. Microreactor according to any of the preceding claims, **characterized in that** the microstructures are produced by etching, thus resulting in an approximately semi-elliptical cross section.

8. Microreactor according to any of Claims 1 to 6, **characterized in that** the microstructures are produced by embossing.

9. Microreactor according to any of the preceding claims, **characterized in that** at least two channel layers are arranged one on top of another and form a layer block, wherein each channel layer has a dedicated inlet and outlet channel, such that different media can flow through the channel layers of the layer block.

10. Microreactor according to Claim 9, **characterized in that** the microchannels of different channel layers of a layer block run in different directions, and are preferably offset at an angle of 90° with respect to one another (cross-current arrangement).

11. Microreactor according to any of the preceding claims, **characterized in that** at least one spacer and connecting means (connecting means) is provided between two individual layers of the channel layer, in order to connect the two layers to one another and to enlarge the cross section and also the active surface of the microchannels.

12. Microreactor according to Claim 11, **characterized in that** the connecting means is embodied as a layer having cutouts or perforations in the region of the microstructures.

13. Microreactor according to Claim 12, **characterized in that** the connecting means is a coated wire surrounding the microstructure, such that the medium remains in the microchannels.

14. Microreactor according to any of the preceding claims, **characterized in that** the microchannels have a width in the region of 400 µm, a depth of 200 µm and a length of 8 mm-20 mm.

15. Microreactor according to any of the preceding claims, **characterized in that** the distance between adjacent microchannels of a layer is in the range of 200-300 µm, such that the webs formed between two microchannels have a width of 200-300 µm.

16. Microreactor according to Claim 5, **characterized in that** the channel layer comprises between 2 and 20 individual microstructured layers.

17. Microreactor according to any of the preceding claims, **characterized in that** the layer stack has a rectangular base area, and preferably has a base area of 50 mm by 50 mm or less.

18. Microreactor according to any of the preceding claims, **characterized in that** the inlet channel and the outlet channel run perpendicularly to the channel layer and the microchannels.

19. Microreactor according to any of the preceding claims, **characterized in that** the individual layers of the layer stack are soldered or welded to one another.

20. Microreactor according to any of the preceding claims, **characterized in that** the microreactor is embodied as a cooler for an electronic component, wherein that area of the channel layer which faces away from the microstructure can be thermally coupled to the component.

21. Microreactor according to Claim 20, **characterized in that** the thermally coupled area has a microstructure.

22. Microreactor according to any of the preceding claims, **characterized in that** a bypass is provided in order to guide the medium from the inlet channel to the outlet channel whilst partly or completely bypassing the microchannels.

23. Microreactor according to Claim 1, **characterized in that** cavities are provided between individual layer stacks in order to provide thermal decoupling.

24. Microreactor according to any of the preceding claims, **characterized in that** the layers consist of different materials.

25. Microreactor according to any of the preceding claims, **characterized in that** at least one layer consists of a metal, preferably copper, aluminium or high-grade steel.

26. Microreactor according to any of the preceding claims, **characterized in that** at least one layer consists of a plastic.

27. Microreactor according to any of the preceding claims, **characterized in that** further components are integrated, preferably chemical reactors and mixing devices.

28. Microreactor according to any of the preceding claims, **characterized in that** a catalyst is applied at least in one microchannel, preferably in the microchannels of an individual layer.

29. Microreactor arrangement, **characterized in that** a plurality of microreactors according to any of Claims 1 to 28 are interconnected with one another in order to provide an integrated device.

## Revendications

1. Microréacteur comprenant
plusieurs couches (10, 32) individuelles rassemblées pour former une pile de couches (42), laquelle pile de couches présente une couche de recouvrement (32) et une couche canal (10), la couche canal (10) comprenant au moins deux couches individuelles (10.1-10.3), qui présentent à chaque fois des microstructures (18) sur au moins un côté (14), lesquelles forment des microcanaux (40) conjointement avec le côté tourné vers elles de la couche de recouvrement adjacente (32) ou de la couche individuelle (10.2-10.3), et
au moins un canal d'entrée (48) et au moins un canal de sortie (47), qui sont en liaison avec les microcanaux (40) de sorte qu'un fluide introduit à travers le canal d'entrée (48) puisse traverser les microcanaux (40) et sortir par le biais du canal de sortie (47), et qui forment une zone de microréacteur (93), **caractérisé en ce que**
plusieurs zones de microréacteur (93) sont prévues à l'intérieur d'une couche canal et sont disposées en forme de matrice, des canaux d'entrée et de sortie (48, 47) de zones de microréacteur (93) adjacentes étant connectés les uns aux autres.

2. Microréacteur selon la revendication 1, **caractérisé en ce que** les couches individuelles (10) sont constituées en un assemblage thermiquement bien couplé ; les couches individuelles (10.1-10.3) de la couche canal (10) sont réalisées de manière identique ; les couches individuelles de la couche canal (10) sont disposées de manière orientée les unes vers les autres, de sorte que des nervures des microcanaux des couches individuelles soient superposées ; et les microcanaux (40) sont connectés au canal d'entrée (48) et au canal de sortie (47).

3. Microréacteur selon la revendication 1, **caractérisé en ce que** les couches individuelles de la couche canal sont réalisées de manière identique.

4. Microréacteur selon la revendication 3, **caractérisé en ce que** les couches individuelles de la couche canal sont disposées de manière orientée les unes vers les autres, de sorte que des nervures des microcanaux des couches individuelles soient superposées.

5. Microréacteur selon l'une quelconque des revendications précédentes, **caractérisé en ce que** la couche canal présente une pluralité des couches individuelles.

6. Microréacteur selon l'une quelconque des revendications précédentes, **caractérisé en ce que** les microcanaux des couches individuelles s'étendent parallèlement les uns aux autres.

7. Microréacteur selon l'une quelconque des revendications précédentes, **caractérisé en ce que** les microstructures sont fabriquées par gravure chimique, une section transversale approximativement semi-elliptique étant ainsi obtenue.

8. Microréacteur selon l'une quelconque des revendications 1 à 6, **caractérisé en ce que** les microstructures sont fabriquées par gaufrage.

9. Microréacteur selon l'une quelconque des revendications précédentes, **caractérisé en ce qu'**au moins deux couches canaux sont disposées l'une au-dessus de l'autre et forment un bloc de couches, chaque couche canal présentant son propre canal d'entrée et de sortie, de sorte que les couches canaux du bloc de couches puissent être parcourues par différents fluides.

10. Microréacteur selon la revendication 9, **caractérisé en ce que** les microcanaux de différentes couches canaux d'un bloc de couches s'étendent dans des directions différentes, de préférence sont décalés suivant un angle de 90° les uns par rapport aux autres (agencement à courants croisés).

11. Microréacteur selon l'une quelconque des revendications précédentes, **caractérisé en ce qu'**au moins un moyen d'espacement et de connexion (moyen de connexion) est prévu entre deux couches individuelles de la couche canal, afin de relier entre elles les deux couches, et d'augmenter la section transversale ainsi que la surface active des microcanaux.

12. Microréacteur selon la revendication 11, **caractérisé en ce que** le moyen de connexion est réalisé sous forme de couche, qui présente dans la région des microstructures des évidements ou des orifices.

13. Microréacteur selon la revendication 12, **caractérisé en ce que** le moyen de connexion est un fil revêtu, qui entoure la microstructure de sorte que le fluide reste dans les microcanaux.

14. Microréacteur selon l'une quelconque des revendications précédentes, **caractérisé en ce que** les microcanaux présentent une largeur de l'ordre de 400 µm, une profondeur de 200 µm, et une longueur de 8 mm - 20 mm.

15. Microréacteur selon l'une quelconque des revendications précédentes, **caractérisé en ce que** la distance entre des microcanaux adjacents d'une couche est de l'ordre de 200 à 300 µm, de sorte que les nervures réalisées entre deux microcanaux présentent une largeur de 200 à 300 µm.

16. Microréacteur selon la revendication 5, **caractérisé en ce que** la couche canal comprend entre 2 et 20 couches microstructurées individuelles.

17. Microréacteur selon l'une quelconque des revendications précédentes, **caractérisé en ce que** la pile de couches présente une surface de base rectangulaire, de préférence une surface de base de 50 mm sur 50 mm ou moins.

18. Microréacteur selon l'une quelconque des revendications précédentes, **caractérisé en ce que** le canal d'entrée et le canal de sortie s'étendent perpendiculairement à la couche canal et aux microcanaux.

19. Microréacteur selon l'une quelconque des revendications précédentes, **caractérisé en ce que** les couches individuelles de la pile de couches sont brasées ou soudées ensemble.

20. Microréacteur selon l'une quelconque des revendications précédentes, **caractérisé en ce que** le microréacteur est réalisé sous forme de refroidisseur pour un composant électronique, la surface de la couche canal opposée à la microstructure pouvant être couplée thermiquement au composant.

21. Microréacteur selon la revendication 20, **caractérisé en ce que** la surface couplée thermiquement présente une microstructure.

22. Microréacteur selon l'une quelconque des revendications précédentes, **caractérisé en ce qu'**il est prévu une dérivation afin de guider le fluide du canal d'entrée au canal de sortie en contournant partiellement ou complètement les microcanaux.

23. Microréacteur selon la revendication 1, **caractérisé en ce que** des cavités entre des piles de couches individuelles sont prévues, afin de réaliser un désaccouplement thermique.

24. Microréacteur selon l'une quelconque des revendications précédentes, **caractérisé en ce que** les couches se composent de matériaux différents.

25. Microréacteur selon l'une quelconque des revendications précédentes, **caractérisé en ce qu'**au moins une couche se compose d'un métal, de préférence de cuivre, d'aluminium ou d'acier spécial.

26. Microréacteur selon l'une quelconque des revendications précédentes, **caractérisé en ce qu'**au moins une couche se compose de plastique.

27. Microréacteur selon l'une quelconque des revendications précédentes, **caractérisé en ce que** d'autres composants sont intégrés, de préférence des réacteurs chimiques et des dispositifs mélangeurs.

28. Microréacteur selon l'une quelconque des revendications précédentes, **caractérisé en ce qu'**un catalyseur est introduit dans au moins un microcanal, de préférence dans les microcanaux d'une couche individuelle.

29. Agencement de microréacteur, **caractérisé en ce que** plusieurs microréacteurs selon l'une quelconque des revendications 1 à 28 sont mis en circuit les uns avec les autres, afin de fournir un composant intégré.
